# EUROPÄISCHE PATENTSCHRIFT

(11) **EP 3 215 895 B1**
(45) Veröffentlichungstag und Bekanntmachung des Hinweises auf die Patenterteilung: **23.02.2022**
(21) Anmeldenummer: 15817060.5
(22) Anmeldetag: 03.11.2015
(51) Int. Cl.: G03F 7/00

(54) **VERFAHREN ZUR DURCHFÜHRUNG EINES KAPILLAR-NANODRUCKS, FELD VON TINTENTROPFEN UND FELD VON DRÄHTEN ERHÄLTLICH NACH DEM VERFAHREN**
METHOD FOR CARRYING OUT CAPILLARY NANOPRINTING, FIELD OF INK DROPS AND FIELD OF WIRES OBTAINED ACCORDING TO THE METHOD
PROCÉDÉ DE RÉALISATION D'UNE NANOIMPRESSION CAPILLAIRE, CHAMP DE GOUTTES D'ENCRE ET CHAMP DE CABLES OBTENUS PAR LEDIT PROCÉDÉ

(30) Priorität: 03.11.2014 DE 102014115969
(43) Veröffentlichungstag der Anmeldung: 13.09.2017
(73) Patentinhaber: Universität Osnabrück, 49074 Osnabrück (DE)
(72) Erfinder: STEINHART, Martin, 49074 Osnabrück (DE); XUE, Longjian, Wuchang Hubei 430072 (CN)
(74) Vertreter: Scholz, Volker
(86) Internationale Anmeldenummer: PCT/DE2015/100462
(87) Internationale Veröffentlichungsnummer: WO 2016/070869

(56) Entgegenhaltungen:
- WO-A2-03/099463
- THIERRY LEÏCHLÉ ET AL: "Nanostructuring surfaces with conjugated silica colloids deposited using silicon-based microcantilevers; Nanostructuring surfaces with conjugated silica colloids deposited using silicon-based microcantilevers", NANOTECHNOLOGY, IOP, BRISTOL, GB, Bd. 16, Nr. 4, 1. April 2005 (2005-04-01), Seiten 525-531, XP020091008, ISSN: 0957-4484, DOI: 10.1088/0957-4484/16/4/032

## Beschreibung

Die vorliegende Erfindung hat ein technisches Verfahren zur Durchführung von Kapillar-Nanodruck, Felder von Tintentropfen oder Folgeprodukte von Feldern dieser Tintentropfen, die mittels Kapillarnanodruck zugänglich sind, sowie Anwendungen dieser Felder von Tintentropfen und von deren Folgeprodukten zum Gegenstand.

Ballistisches Aufbringen von Tinte auf zu bedruckende Oberflächen durch Methoden wie Inkjet-Drucken^{i,ii} and Elektrosprayingⁱⁱⁱ beruht auf dem Transport von in Richtung der zu bedruckenden Oberfläche beschleunigten Tintentröpfchen durch ein Volumen zwischen einer Düse oder einer ähnlichen Vorrichtung und der zu bedruckenden Oberfläche. Ballistisches Drucken ist jedoch mit erheblichen Nachteilen verbunden: Im Falle des Inkjet-Druckens werden Tropfen mit Volumina von deutlich über einem Pikoliter zur zu bedruckenden Oberfläche überführt; eine Tropfengröße im Bereich oberhalb von einem Pikoliter stellt das untere Volumenlimit dar, welches mit Inkjetdruck technisch realisierbar ist. Im Falle des Elektrosprayens ist die Einstellung enger Größenverteilungen der Tintentropfen sowie die präzise Positionierung einzelner Tintentropfen auf der zu bedruckenden Oberfläche nicht möglich. Ein genereller intrinsischer Nachteil ballistischer Druckmethoden besteht darin, dass beim Auftreffen der Tintentropfen auf die zu bedruckende Oberfläche die kinetische Energie der Tintentropfen schlagartig dissipiert werden muss. Dieser Dissipationsprozess ist mit schwer kontrollierbarer mechanischer Verformung oder Zerstäubung der Tintentropfen verbunden.

Konventionelle Nanolithographie nach dem Stand der Technik umfasst einerseits Rastersonden-Nanolithographie^{iv-viii} und andererseits kontaktlithographische Methoden,^{ix-xii} die auf der Verwendung von topographisch oder chemisch strukturierten Stempeln basieren. Bestimmte Ausführungsformen der Rastersonden-Nanolithographie erlauben die Zuführung einer Tinte an eine Cantilever-Spitze oder an die Spitzen von Mikropipetten,^{xiii,xiv} so dass über Kapillarbrücken Flüssigkeiten auf andere Oberflächen übertragen werden kann.^{xv-xvii} Rastersonden-Nanolithographie ist jedoch eine serielle Methode, die lediglich das sukzessive Abscheiden von Tintentropfen oder Tintenstrukturen mit einer einzelnen Cantilever-Spitze erlaubt. Das Beschreiben von Flächen mittels Rastersonden-Nanolithographie zwischen jedem einzelnen Schreib/Druckschritt beziehungsweise das Abscheiden von Strukturen, die größer als die Abmessungen der Rastersonde sind, erfordert kontrollierten lateralen Versatz entweder der Rastersonde oder der zu bedruckenden/zu beschreibenden Fläche. Da Rastersonden-Nanolithographie eine intrinsisch serielle Methode mit geringem Durchsatz ist, können nur kleine Flächen bearbeitet werden. Das Abscheiden von Feldern von Tintentropfen auf einer Fläche von 100 µm × 100 µm benötigt so zumindest mehrere Minuten.

Stempelbasierte kontaktlithographische Methoden erlauben zwar das Bedrucken großer Flächen und lassen sich auch als kontinuierliche Rollenprozesse ausführen.^{xviii} Dabei werden massive, also nicht poröse Stempel verwendet. Nachteilig ist jedoch, dass bei stempelbasierten kontaktlithographischen Methoden die zu druckende Tinte auf die zu bedruckende Fläche überführt werden muss, indem die Tinte zunächst auf der Oberfläche des Stempels adsorbiert wird, der Stempel dann auf die zu bedruckende Fläche aufgebracht wird und dann die auf der Oberfläche des Stempels adsorbierte Tinte auf die zu bedruckende Fläche übertragen wird. Um in gleicher Qualität einen weiteren Druckzyklus durchführen zu können, muss zunächst erneut Tinte auf der Oberfläche des Stempels adsorbiert werden. Die Überführung von Tinte an die Oberfläche des Stempels durch Adsorption der Tinte auf der Stempeloberfläche ist ein technisch aufwändiger zusätzlicher Prozessschritt stempelbasierter kontaktlithographischer Methoden, welcher pro Zyklus bis zu mehreren Minuten in Anspruch nehmen kann.^{xii} Das Aufnehmen von Tinte durch die Stempel erfordert unter Umständen komplexe mechanische Vorrichtungen zum Bewegen der Stempel zu den Tintenreservoiren und zur Bereitstellung von Tinte mittels eines Systems, dass kontrolliertes Aufnehmen von Tinte durch die Stempel über eine Grenzfläche zwischen Stempel und Tintenreservoir ermöglicht. Ein weiterer Nachteil stempelbasierter kontaktlithographischer Methoden nach dem Stand der Technik besteht darin, dass diese lediglich die Übertragung dünner Schichten aus einer oder wenigen molekularen Monolagen des zu verdruckenden Materials erlauben.

Es ist daher die Aufgabe der vorliegenden Erfindung, ein Druckverfahren zur Erzeugung von Feldern von Tintentropfen bereitzustellen, das die Nachteile des Stands der Technik überwindet, insbesondere eine Verringerung der Volumina der erzeugten Tropfen sowie deren präzise Positionierung auf einer Oberfläche erlaubt. Es ist ferner Aufgabe der vorliegenden Erfindung, ein Druckverfahren bereitzustellen, das die gleichzeitige Erzeugung einer großen Zahl diskreter Tintentropfen auf einer zu bedruckenden Oberfläche, die großflächige Erzeugung von Feldern diskreter Tintentropfen auf einer zu bedruckenden Oberfläche sowie die Kontrolle der mechanischen Verformung der Tintentropfen erlaubt. Darüber hinaus ist es eine Aufgabe der vorliegenden Erfindung, eine entsprechendes Verfahren bereitzustellen, mittels der vermieden werden kann, die zur Erzeugung der Tropfen vorgesehene Tinte zunächst auf die Oberfläche eines Stempels aufzubringen.

Diese Aufgabe wird erfindungsgemäß gelöst durch ein Verfahren zur Durchführung eines Kapillar-Nanodrucks, umfassend die Schritte des
a) Bereitstellens einer Vorrichtung, umfassend zumindest eine monolithische Kombination aus einem Substrat (1) und einem oder mehreren Kontaktelementen (2), wobei zumindest Teile der Kontaktelemente (2) eine poröse Struktur haben, vorzugsweise auch zumindest Teile des Substrats eine poröse Struktur haben, besonders bevorzugt die gesamte monolithische Kombination eine poröse Struktur hat;
b) des Bereitstellens einer zu bedruckenden Oberfläche (3);
c) des Bereitstellens einer Tinte (4) in zumindest einem Teil der porösen Struktur der monolithischen Kombination;
d) des Verringerns des Abstands zwischen der zu bedruckenden Oberfläche (3) und den Kontaktelementen (2), um eine oder mehrere Kapillarbrücken aus Tinte (4) zwischen den Kontaktelementen (2) und der zu bedruckenden Oberfläche (3) auszubilden;
e) des anschließenden Vergrößerns des Abstands zwischen den Kontaktelementen (2) und der zu bedruckenden Oberfläche (3), wobei die Kontaktelemente (2) und Oberfläche (3) nach erfolgter Annäherung und vor dem Vergrößern des Abstandes für eine ausgewählte Zeit in einem bestimmten konstanten Abstand voneinander gehalten werden können oder aber das Vergrößern des Abstandes unmittelbar nach Beendigung der Annäherung von Kontaktelementen (2) und Oberfläche (3) erfolgen kann.

Bevorzugt ist vorgesehen, dass die zumindest in Teilbereichen der monolithischen Kombination aus einem Substrat und einem oder mehreren Kontaktelementen vorhandene poröse Struktur so ausgeführt ist, dass durch die poröse Struktur Tinte zu den dem Substrat abgewandten Enden der Kontaktelemente zugeführt werden kann. Beispielsweise ist vorstellbar, dass die poröse Struktur parallel angeordnete zylindrische Poren enthält. Besonders bevorzugt ist, dass die zumindest in Teilbereichen der monolithischen Kombination aus einem Substrat und einem oder mehreren Kontaktelementen vorhandene poröse Struktur ein kontinuierliches Porensystem enthält. Besonders bevorzugt ist, dass poröse Strukturen aufweisende Teilbereiche der monolithischen Kombinationen aus einem Substrat und einem oder mehreren Kontaktelementen oder die monolithischen Kombinationen aus einem Substrat und einem oder mehreren Kontaktelementen in ihrer Gesamtheit eine bikontinuierliche interpenetrierende Morphologie aufweisen, wobei ein kontinuierliches Porensystem Bestandteil dieser bikontinuierlich-interpenetrierenden Morphologie ist. Vorzugsweise ist eine poröse Struktur vorgesehen, die ein isotropes oder anisotropes kontinuierliches Porensystem aufweist, welches vorzugsweise Bestandteil einer bikontinuierlich-interpenetrierenden Morphologie ist.

Bevorzugt ist vorgesehen, dass die Oberfläche der monolithischen Kombination aus Substrat und Kontaktelementen, zumindest in Teilbereichen Porenöffnungen aufweist und bevorzugt die Oberfläche der Kontaktelemente zumindest in Teilbereichen Porenöffnungen aufweist.

Außerdem kann vorgesehen sein, dass der Anteil der Porenöffnungen an der Gesamtoberfläche der monolithischen Kombination aus Substrat und Kontaktelementen größer als 10%, vorzugsweise größer als 25%, insbesondere bevorzugt größer als 40%, ist.

Besonders bevorzugt ist vorgesehen, dass die monolithische Kombination aus Substrat und Kontaktelementen zumindest ein Material enthält, das ausgewählt ist aus der Gruppe, bestehend aus:
i) organischen Polymeren wie Poly(p-xylylen), Polyacrylamid, Polyimiden, Polyestern, Polyolefinen, Polystyrolen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polyethylenen,
ii) fluorhaltigen Polymeren wie Polyvinylidendifluorid, Polytrifluorethylen, Polytretrafluorethylen, Polyhexafluorpropylen,
iii) Dendrimeren und/oder sternartigen Polymeren und/oder kammartigen Polymeren,
iv) biologischen Polymeren wie Polysacchariden, Cellulose (modifiziert oder nichtmodifiziert), Alginaten, Polypeptiden, Collagen, DNA, RNA,
v) Polymeren, die aus mindestens zwei verschiedenen Wiederholungseinheiten aufgebaut sind, bevorzugt in Form von statistischen Copolymeren und/oder Blockcopolymeren und/oder Propfcopolymeren und/oder Dendrimeren,
vi) Blockcopolymeren, die zumindest zwei Blöcke unterschiedlicher Polarität enthalten, wobei besagte Blöcke unter anderem ausgewählt sein können aus Polystyrol-Blöcken und/oder Polyisopren-Blöcken und/oder Polybutadien-Blöcken und/oder Polypropylen-Blöcken und/oder Polyethylen-Blöcken und/oder Poly(methylmethacrylat)-Blöcken und/oder Poly(vinylpyridin)-Blöcken und/oder Poly(vinylpyrrolidon)-Blöcken und/oder Poly(vinylalkohol)-Blöcken und/oder Poly(ethylenoxid)-Blöcken und/oder Poly(propylenoxid)-Blöcken und/oder Poly(butylmethacrylat)-Blöcken und/oder Poly(N-isopropyl-acrylamid)-Blöcken und/oder Poly(dimethylsiloxan)-Blöcken und/oder Polyacrylat-Blöcken und/oder Poly(vinylacetat)-Blöcken und/oder Poly(vinyliden difluorid)-Blöcken und/oder Polythiophen-Blöcken und/oder Poly(styrolsulfonat)-Blöcken,
vii) Copolymeren, die fluorhaltige Comonomere, bevorzugt fluorhaltige Comonomere, die sich aus Fluorethylen, Difluorethylen, Trifluorethylen, Tetrafluorethylen oder Hexafluorpropylen ableiten, enthalten,
viii) leitfähigen und/oder halbleitenden Polymeren,
ix) Polyelektrolyten,
x) Kombinationen aus zwei oder mehreren Polymeren und/oder anorganischen Materialien,
xi) Metallen, vorzugsweise Gold, Silber, Platin, Palladium, Wolfram, Kupfer, Titan, Aluminium, Tantal,
xii) beliebigen Mischungen verschiedener Metalle,
xii) Oxiden, die zumindest ein Metall und Sauerstoff oder zumindest einen Halbleiter und Sauerstoff enthalten, vorzugsweise Siliziumoxid, Titanoxid, Aluminiumoxid und Tantaloxid,
xiii) anorganischen Halbleitern, vorzugsweise Silizium,
und Mischungen derselben.

Ferner kann vorgesehen sein, dass die Kontaktelemente zylindrisch, stabförmig, kugelförmig, halbkugelförmig, rechteckig, quadratisch oder streifenförmig sind.

Vorzugsweise kann vorgesehen sein, dass die dem Substrat abgewandten Enden der Kontaktelemente halbkugelförmig, pyramidal oder eben sind.

Bevorzugt ist, dass die Kontaktelemente röhrenartig sind.

Besonders bevorzugt ist, dass die den Kontaktelementen abgewandte Seite des Substrats mit einer weiteren porösen Schicht verbunden ist.

Es kann vorzugsweise vorgesehen sein, dass das Substrat zylinderförmig oder zylindermantelförmig ist und die Kontaktelemente an der äußeren Oberfläche des zylinderförmigen oder zylindermantelförmigen Substrats angeordnet sind.

Vorzugsweise wird die Aufgabe gelöst durch ein Verfahren zur Durchführung eines Kapillar-Nanodrucks, umfassend die Schritte:
a) Bereitstellen einer Vorrichtung, umfassend zumindest eine monolithische Kombination aus einem Substrat (1) und einem oder mehreren Kontaktelementen (2), wobei zumindest Teile der Kontaktelemente (2) eine poröse Struktur haben, vorzugsweise auch zumindest Teile des Substrats eine poröse Struktur haben, besonders bevorzugt die gesamte monolithische Kombination eine poröse Struktur hat, wobei das Substrat zylinderförmig oder zylindermantelförmig ist und die Kontaktelemente an der äußeren Oberfläche des zylinderförmigen oder zylindermantelförmigen Substrats angeordnet sind; ;
b) Bereitstellen einer zu bedruckenden Oberfläche (3);
c) Bereitstellen einer Tinte in zumindest einem Teil der porösen Struktur der monolithischen Kombination;
d) Verringern des Abstands zwischen der zu bedruckenden Oberfläche und den Kontaktelementen, wobei das Verringern des Abstands zwischen der zu bedruckenden Oberfläche und den Kontaktelementen vor oder nach dem Bereitstellen einer Tinte in zumindest einem Teil der porösen Struktur der monolithischen Kombination erfolgen kann;
e) Bewegung der zu bedruckenden Fläche in Kontakt mit der Vorrichtung, in welcher die monolithische Kombination aus Substrat und Kontaktelementen eine Rotationsbewegung um ihre Längsachse ausführt, oder Rollen der in einer Vorrichtung enthaltenen
monolithischen Kombination aus Substrat und Kontaktelementen über Oberfläche.

Erfindungsgemäß bevorzugt ist dabei, dass die Tinte kontinuierlich oder schubweise an die Kontaktelemente herangeführt wird.

Bevorzugt ist, dass das Verringern und/oder das Vergrößern des Abstands zwischen den Kontaktelementen und der zu bedruckenden Oberfläche mit einer Geschwindigkeit von höchstens 1 µm/s, vorzugsweise 100 nm/s, besonders bevorzugt 10 nm/s erfolgt.

Besonders bevorzugt ist, dass das Ausbilden der Kapillarbrücke aus Tinte durch Messung der zur Annäherung erforderlichen Kraft und/oder durch Erzeugung eines elektrischen Kontakts zwischen der monolithischen Kombination aus Substrat und Kontaktelementen sowie der zu bedruckenden Oberfläche detektiert wird.

Ebenfalls bevorzugt ist, dass das Verfahren in Gegenwart eines elektrischen und/oder magnetischen Felds durchgeführt wird.

Weiterhin bevorzugt ist, dass die zu bedruckende Oberfläche mit einer Flüssigkeit bedeckt ist, die nicht identisch mit der Tinte ist und im Folgenden als Matrixflüssigkeit bezeichnet wird, und dass durch Kapillarnanodruck Tintentropfen auf der zu bedruckenden Oberfläche erzeugt werden, die, soweit deren Oberfläche nicht in Kontakt mit der bedruckten Oberfläche steht, von besagter Matrixflüssigkeit umhüllt ist. Es kann vorgesehen sein, dass die Matrixflüssigkeit, die Tintentropfen, oder sowohl die Matrixflüssigkeit als auch die Tintentropfen ganz oder in Teilbereichen verfestigt werden.

Die Aufgabe wird ferner gelöst durch ein Feld von Tintentropfen oder von deren Folgeprodukten auf einer Oberfläche, vorzugsweise erhältlich nach dem erfindungsgemäßen Verfahren.

Dabei ist besonders bevorzugt vorgesehen, dass die das Feld bildenden Tintentropfen oder deren Folgeprodukte jeweils ein Volumen von höchsten einem Picoliter, vorzugsweise einem Femtoliter, besonders bevorzugt einem Attoliter, haben.

Ferner wird die Aufgabe gelöst durch ein Feld von Drähten oder deren Folgeprodukten auf einer Oberfläche erhältlich nach dem erfindungsgemäßen Verfahren. Die Drähte oder deren Folgeprodukte können dabei senkrecht zur Oberfläche orientiert vorliegen. Ebenso können die Längsachsen der Drähte oder von deren Folgeprodukten relativ zur Oberfläche verkippt sein, so dass der von der Oberfläche und den Längsachsen eingeschlossene Winkel kleiner als 90°, bevorzugt kleiner als 75° und besonders bevorzugt kleiner als 60° ist.

Desweiteren kann vorgesehen sein, dass die Drähte oder deren Folgeprodukte einen Durchmesser von weniger als 500 nm, vorzugsweise 100 nm, besonders bevorzugt 30 nm, haben.

Außerdem kann bevorzugt vorgesehen sein, dass die Drähte oder deren Folgeprodukte eine Länge von mehr als 500 nm, vorzugsweise mehr als 1 µm, besonders bevorzugt 5 µm, haben.

Weiterhin kann vorgesehen sein, dass die Tintentropfen oder Drähte oder deren Folgeprodukte zumindest in Teilbereichen aus Flüssigkeit bestehen. Ebenso kann jedoch vorgesehen sein, dass die Tintentropfen oder Drähte ganz oder in Teilbereichen verfestigt sind.

Die Aufgabe wird ebenso gelöst durch ein Feld von Beschichtungen oder von deren Folgeprodukten auf einer Oberfläche, vorzugsweise erhältlich nach dem erfindungsgemäßen Verfahren.

Dabei ist bevorzugt, dass die Beschichtungen oder deren Folgeprodukte jeweils einen Durchmesser von weniger als einem Mikrometer, bevorzugt von weniger als 100 nm, und besonders bevorzugt von weniger als 20 nm haben.

Das Feld von Tintentropfen und/oder Drähten und/oder Beschichtungen und/oder Folgeprodukten von Tintentropfen und/oder Drähten und/oder Beschichtungen kann bevorzugt eine Fläche von mindestens 100 Quadratmikrometern, besonders bevorzugt von mindestens einem Quadratmillimeter, und am meisten bevorzugt von mindestens einem Quadratzentimeter aufweisen.

Bevorzugt weisen die das Feld bildenden Tintentropfen und/oder Drähte und/oder Beschichtungen und/oder Folgeprodukte von Tintentropfen und/oder Drähten und/oder Beschichtungen jeweils einen Abstand zu ihren nächsten Nachbarn innerhalb des Feldes von weniger als einem Mikrometer, bevorzugt von weniger als 500 nm und besonders bevorzugt von weniger als 100 nm auf.

Weiterhin ist bevorzugt, dass das Feld aus Tintentropfen und/oder Drähten und/oder Beschichtungen und/oder Folgeprodukten von Tintentropfen und/oder Drähten und/oder Beschichtungen eine Flächendichte von mehr als einem Tintentropfen oder einem Draht oder einer Beschichtung oder einem Folgeprodukt pro Quadratmikrometer,bevorzugt von mehr als 10 Tintentropfen und/oder Drähten und/oder Beschichtungen und/oder Folgeprodukten pro Quadratmikrometer, besonders bevorzugt von mehr als 130 Tintentropfen und/oder Drähten und/oder Beschichtungen und/oder Folgeprodukten pro Quadratmikrometer aufweist.

Noch bevorzugter bilden die das Feld bildenden Tintentropfen und/oder Drähte und/oder Beschichtungen und/oder Folgeprodukte von Tintentropfen und/oder Drähten und/oder Beschichtungen ein regelmäßiges Gitter, bevorzugt ein quadratisches Gitter, besonders bevorzugt ein hexagonales Gitter.

Die Aufgabe wird schließlich gelöst durch die Verwendung der Vorrichtung zur Erzeugung von Feldern aus ganz oder teilweise verfestigten Tintentropfen und/oder Feldern aus ganz oder teilweise flüssigen Tintentropfen und/oder Feldern aus ganz oder teilweise verfestigten Nanodrähten und/oder Feldern aus ganz oder teilweise flüssigen Nanodrähten und/oder Feldern aus Nanopartikeln und/oder Feldern aus punktartigen Beschichtungen auf der zu bedruckenden Oberfläche und/oder Feldern aus in der zu bedruckenden Oberfläche befindlichen Poren.Das erfindungsgemäße Verfahren, die erfindungsgemäßen Felder von Tintentropfen sowie die erfindungsgemäßen Anwendungen sollen im Folgenden unter Bezugnahme auf die Figuren im Detail beschrieben werden.

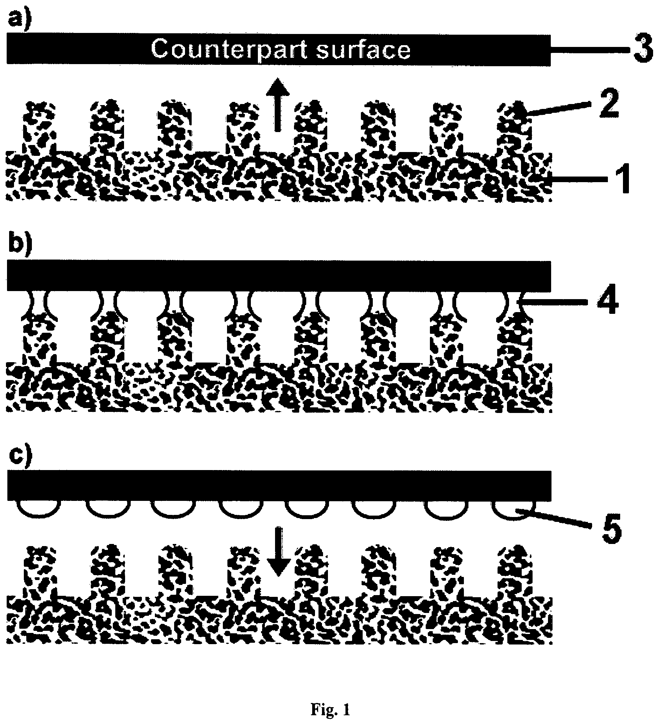

**Fig. 1****:** Beispielhafte Darstellung des Kapillar-Nanodrucks. a) Eine monolithische Kombination aus einem Substrat (1) und Kontaktelementen (2), die ein durchgehendes Porensystem aufweist, wird mit Tinte befüllt. b) Nähert sich die monolithische Kombination aus Substrat (1) und Kontaktelementen (2) einer zu bedruckenden Oberfläche (3), bilden sich zwischen Kontaktelementen (2) und zu bedruckender Oberfläche (3) Kapillarbrücken (4) aus Tinte. c) Wird die monolithische Kombination aus Substrat (1) und Kontaktelementen (2) von der zu bedruckenden Oberfläche (3) wieder zurückgezogen, reißen die Kapillarbrücken aus Tinte (4) kontrolliert auseinander, und auf der zu bedruckenden Oberfläche (3) bleiben Felder von Tintentropfen (5) zurück.

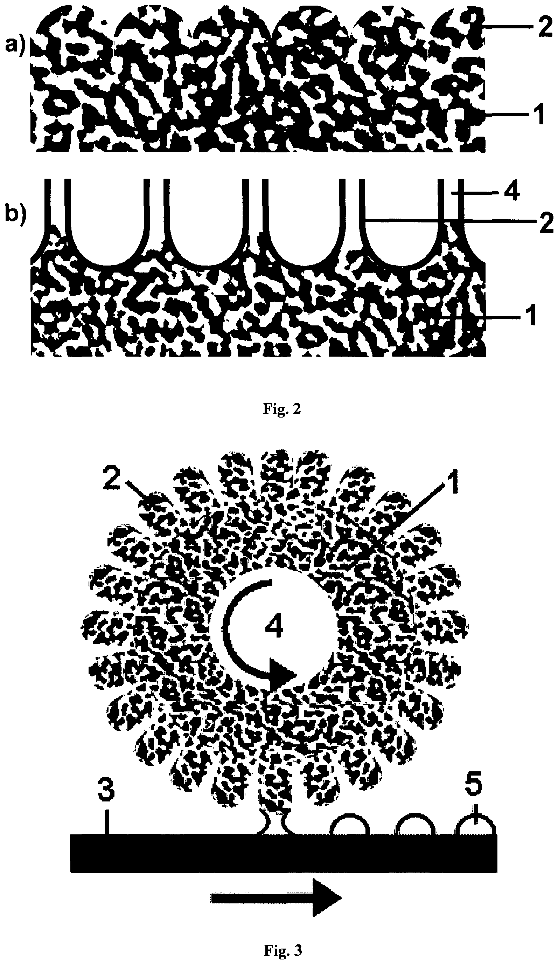

**Fig. 2**: Beispiele für Kontaktgeometrien der Kontaktelemente (2), die mit einem Substrat (1) eine monolithische Kombination bilden. a) Halbkugelförmige Kontaktelemente (2); b) röhrchenartige Kontaktelemente (2) mit einem durchgehenden zylindrischen Hohlraum, durch den Tinte (4) zur zu bedruckenden Oberfläche fließen kann.
Fig. 3: Beispielhafte Ausführung von Kapillar-Nanodruck im kontinuierlichen Rollenmodus. Die monolithische Kombination aus Substrat (1) und Kontaktelementen (2) ist Bestandteil einer Rolle; Tinte (4) wird der monolithischen Kombination aus Substrat (1) und Kontaktelementen (2) über einen Rollenkern und die den Kontaktelementen (2) abgewandte Seite des Substrats (1) zugeführt. Durch eine Rotationsbewegung der Rolle mit der monolithischen Kombination aus Substrat (1) und Kontaktelementen (2) kann eine Fläche (3), die mit einer der Rotationsgeschwindigkeit der Rolle angepassten Geschwindigkeit an der Rolle vorbeigeführt wird, mit Tintentropfen (5) bedruckt werden.

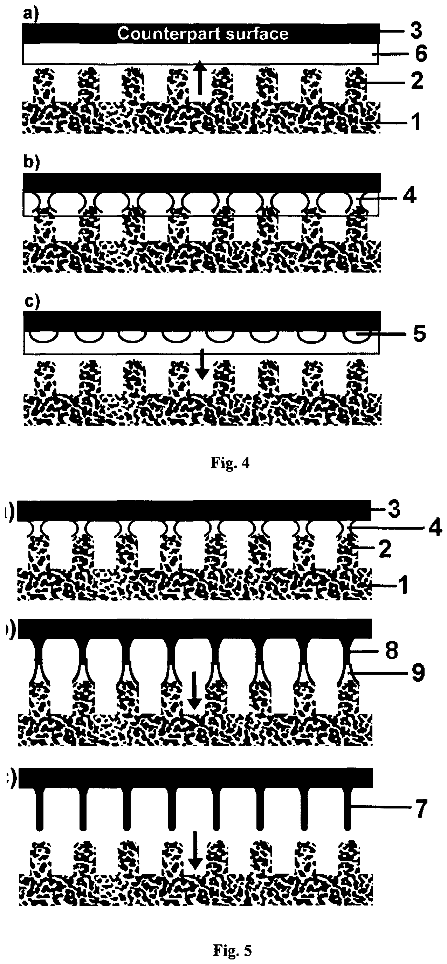

Fig. 4: Exemplarische Darstellung des Kapillar-Nanodrucks auf eine zu bedruckende Oberfläche, die mit einer Matrixflüssigkeit bedeckt ist. a) Eine mit Tinte gefüllte monolithische Kombination aus Substrat (1) und Kontaktelementen (2) wird an eine zu bedruckende Fläche (3) angenähert, die mit einer Matrixflüssigkeit (6) bedeckt ist. b) Im Verlauf der Annäherung tauchen die Kontaktelemente (2) in die Matrixflüssigkeit (6) ein, und es bilden sich innerhalb der Matrixflüssigkeit (6) Kapillarbrücken aus Tinte (4) zwischen den Kontaktelementen (2) und der zu bedruckenden Fläche (3). c) Nach dem Trennen von Kontaktelementen (2) und bedruckter Fläche (3) reißen die Kapillarbrücken aus Tinte (4), so dass auf der bedruckten Fläche (3) Felder von Tintentropfen (5) abgeschieden werden, die außer an der Kontaktfläche zwischen Tintentropfen (5) und bedruckter Fläche (3) vollständig von Matrixflüssigkeit (6) umhüllt sind.
Fig. 5: Erzeugung von Feldern von Drähten (7) durch Kapillar-Nanodruck. a) Annäherung mit Tinte gefüllter Kontaktelemente (2) an die zu bedruckende Oberfläche (3) führt zur Ausbildung von Kapillarbrücken aus Tinte (4) zwischen den Kontaktelementen (2) und der bedruckten Oberfläche (3). b) Die Trennung von Kontaktelementen (2) und bedruckter Oberfläche (3) erfolgt derart, dass die Kapillarbrücken aus Tinte (4) nicht brechen. Stattdessen werden diese ausgehend von der bedruckten Fläche (3) verfestigt, so dass die Verfestigungsfront ein verfestigtes Segment (8) der Kapillarbrücke aus Tinte auf der Seite der bedruckten Oberfläche (3) von einem flüssigen Teil (9) der Kapillarbrücke in Kontakt mit den Kontaktelementen (2) trennt. c) Durch geeignete Maßnahmen wie Unterbrechung der Tintenzufuhr in die Kontaktelemente (2) oder Erhöhung der Trennungsgeschwindigkeit von Kontaktelementen (2) und bedruckter Fläche (3) reißen die Kapillarbrücken, so dass Felder von Drähten auf der bedruckten Fläche (3) erzeugt werden.

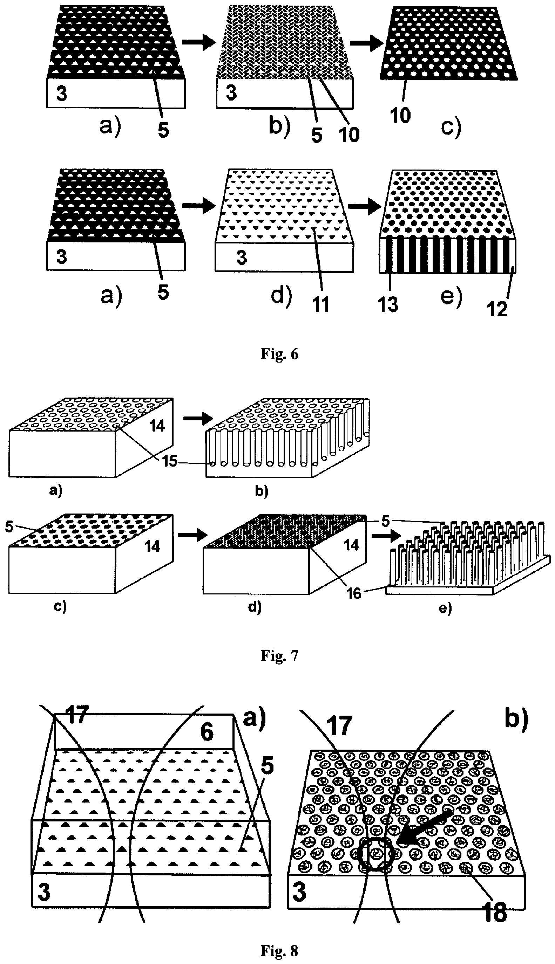

**Fig. 6**. Exemplarische Darstellung der Verwendung von Nanotropfenfeldern für Nanotropfen-Lithographie. a) Nanotropfen-Arrays (5) werden mit Kapillar-Nanodruck auf eine Fläche (3) abgeschieden. b) In einer Ausführungsvariante dienen die Nanotropfen-Arrays (5) als Maske für die Modifizierung der Fläche (3) mit einer weiteren Schicht (10). Ablösen der weiteren Schicht (10) ergibt Schicht (10) als freistehende Membran mit Poren an den Stellen der Nanotropfen (5). d) Bestehen die Nanotropfen (5) aus korrosiver Tinte, können in einer weiteren Ausführungsvariante an den Stellen, an denen Nanotropfen abgeschieden wurden, Vertiefungen (11) in Material (12) geätzt werden. e) Die Vertiefungen (11) dienen als Keime, um mittels geeigneter Ätzprozesse Poren (13) an den Positionen der Vertiefungen (11) in Fläche (3) zu ätzen.
**Fig. 7****:** Metall-assistiertes Ätzen von Silizium mit Hilfe von Kapillar-Nanodruck. a) Felder von Tropfen einer Tinte (5), die Vorläuferverbindungen für geeignete Metalle enthält, werden auf Siliziumwafer (14) aufgebracht, und die Vorläuferverbindungen der Metalle werden in die betreffenden Metalle umgewandelt. Als Ergebnis entstehen Felder von Metallnanopartikeln (15). b) Durch metall-assistiertes Ätzen entstehen an den Positionen der Metallnanopartikel (15) Poren. c) In einer weiteren Ausführungsvariante werden durch Kapillar-Nanodruck zunächst Felder von Tropfen einer Tinte (5) auf einen Siliziumwafer (14) aufgebracht. Anschließend wird der Siliziumwafer mit geeigneten Methoden mit einem für metall-assistiertes Ätzen geeigneten Metall (16) beschichtet. Durch metall-assistiertes Ätzen bleiben an den Positionen der Tintentropfen (5) Silizium-Nanostäbe erhalten, da dort Metall (16) nicht in Kontakt mit Si ist.
Fig. 8: a) Pseudoergodische Labor-in-Nanotropfen-Konfiguration. Dichte Felder von Tintentropfen (5) werden mittels Kapillar-Nanodruck auf eine mit Matrixflüssigkeit (6) bedeckte transparente Fläche (3) abgeschieden. Durch Verfestigen der Matrixflüssigkeit (6) werden die Tintentropfen (5) eingekapselt, wobei die verfestigte Matrixflüssigkeit (6) vorzugsweise transparent ist. Vorzugsweise werden die Felder eingekapselter Tintentropfen (5) so ausgeführt, dass einzelne Tintentropfen mikroskopisch auflösbar sind. Beispielhaft ist das Fokusvolumen (17) eines konfokalen Laser-Scanning-Mikroskopes dargestellt. b) *Labon*-*chip*-Konfiguration. Mittels Kapillar-Nanodruck werden Felder von punktartigen Tintentropfen erzeugt, die nach dem Verfestigten punktartige Beschichtungen (18) bilden, auf denen wiederum Analyt-Moleküle immobilisiert werden können. Die Felder der punktartigen Beschichtungen (18) werden bevorzugt so ausgeführt, dass einzelne punktartige Beschichtungen mikroskopisch auflösbar sind. Beispielhaft ist wiederum das Fokusvolumen (17) eines konfokalen Laser-Scanning-Mikroskops dargestellt. In beiden in Fig. 8 dargestellten Beispielen ist beispielsweise auch eine Auflösung der Tintentropfen oder von deren Folgeprodukten durch Totale Interne Reflektionsfluoreszenzmikroskopie denkbar.

Die mittels Kapillar-Nanodruck erzeugten Felder von Tintentropfen weisen dabei bevorzugt Flächen von größer als 100 Quadratmikrometern, besonders bevorzugt Flächen von größer als einem Quadratmillimeter und am meisten bevorzugt von größer als einem Quadratzentimeter auf. Die besagte Felder bildenden Tintentropfen weisen bevorzugt Volumina von unter einem Pikoliter, besonders bevorzugt von unter einem Femtoliter, und am meisten bevorzugt von unter einem Attoliter auf. Das Grundprinzip des Kapillar-Nanodrucks ist beispielhaft in Fig. 1 dargestellt: ein Substrat (1) sowie mit Substrat (1) verbundene Kontaktelemente (2) enthalten ganz oder in Teilbereichen eine poröse Struktur, die bevorzugt mittlere Porengrößen von weniger als 500 nm, besonders bevorzugt mittlere Porengrößen von weniger als 100 nm und am meisten bevorzugt mittlere Porengrößen von weniger als 50 nm aufweist. Die Kontaktelemente (2) weisen jedoch in jedem Fall besagte poröse Struktur auf. Das Substrat (1) bildet mit den Kontaktelementen (2) eine monolithische Kombination. Die in der monolithischen Kombination aus Substrat (1) und Kontaktelementen (2) enthaltene poröse Struktur ist in ihrer gesamten Ausdehnung innerhalb der monolithischen Kombination aus Substrat (1) und Kontaktelementen (2) kontinuierlich. Folglich weist die monolithische Kombination aus Substrat (1) und Kontaktelementen (2) die Eigenschaft auf, dass der Transport fluider Phasen durch deren Gesamtvolumen oder durch diejenigen ihrer Teilbereiche, die das kontinuierliche Porensystem aufweisen, möglich ist. Das Volumen des Porensystems der monolithischen Kombination aus Substrat (1) und Kontaktelementen (2) kann somit ganz oder teilweise mit einer beliebigen, als Tinte fungierenden Flüssigkeit befüllt werden. Bringt man die Kontaktelemente in nahen Kontakt zu einer zu bedruckenden Oberfläche (3), bilden sich zwischen den mit Tinte befüllten Kontaktelementen (2) und der zu bedruckenden Oberfläche (3) Kapillarbrücken (4) aus Tinte. Entfernt man die monolithische Kombination aus Substrat (1) und Kontaktelementen (2) wieder von der zu bedruckenden Oberfläche (3), kommt es zum kontrollierten Auseinanderreißen der Kapillarbrücken aus Tinte (4). Auf der zu bedruckenden Oberfläche (3) verbleiben Felder von Tintentropfen (5), wobei die Positionen der Tintentropfen (5) durch die Anordnung der Kontaktelemente (2) vorgegeben sind. Die zu bedruckende Oberfläche (3) kann in Form einer Bahn des zu bedruckenden Materials, als zweidimensionale flächenhafte Struktur beliebiger Form, als Film, Folie, oder Schnitt vorliegen. Ebenso kann sich die zu bedruckende Oberfläche (3) auf einem dreidimensionalen Körper befinden und in eine oder mehrere Raumrichtungen gekrümmt sein.

Die technische Vorrichtung zur Durchführung von Kapillar-Nanodruck enthält somit zumindest eine monolithische Kombination aus Substrat (1) und Kontaktelementen (2), die wiederum ganz oder in Teilbereichen ein kontinuierliches Porensystem enthält. Dabei ist es vorteilhaft, wenn die Oberfläche der monolithischen Kombination aus Substrat (1) und Kontaktelementen (2) Porenöffnungen aufweist. Der Anteil der Porenöffnungen an der Gesamtoberfläche der monolithischen Kombination aus Substrat (1) und Kontaktelementen (2) ist bevorzugt größer als 10 %, besonders bevorzugt größer als 25 %, am meisten bevorzugt größer als 40 %. In einer vorteilhaften exemplarischen Ausführungsvariante weisen die monolithischen Kombinationen aus Substrat (1) und Kontaktelementen (2) hexagonale Felder von Kontaktelementen (2) mit Durchmessern von ~60 nm, nächster-Nachbar-Abständen von ~100 nm sowie Flächendichten von ~130 Kontaktelementen (2) pro µm² auf einer Gesamtfläche von 9 cm² auf.

Die monolithische Kombination aus Substrat (1) und Kontaktelementen (2) enthält vorzugsweise zumindest ein Material oder mehrere Materialien ausgewählt aus:
i) organischen Polymeren wie Poly(p-xylylen), Polyacrylamid, Polyimiden, Polyestern, Polyolefinen, Polystyrolen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polyethylenen,
ii) fluorhaltigen Polymeren wie Polyvinylidendifluorid, Polytrifluorethylen, Polytretrafluorethylen, Polyhexafluorpropylen,
iii) Dendrimeren und/oder sternartigen Polymeren und/oder kammartigen Polymeren,
iv) biologischen Polymeren wie Polysacchariden, Cellulose (modifiziert oder nichtmodifiziert), Alginaten, Polypeptiden, Collagen, DNA, RNA,
v) Polymeren, die aus mindestens zwei verschiedenen Wiederholungseinheiten aufgebaut sind, bevorzugt in Form von statistischen Copolymeren und/oder Blockcopolymeren und/oder Propfcopolymeren und/oder Dendrimeren,
vi) Blockcopolymeren, die zumindest zwei Blöcke unterschiedlicher Polarität enthalten, wobei besagte Blöcke unter anderem ausgewählt sein können aus Polystyrol-Blöcken und/oder Polyisopren-Blöcken und/oder Polybutadien-Blöcken und/oder Polypropylen-Blöcken und/oder Polyethylen-Blöcken und/oder Poly(methylmethacrylat)-Blöcken und/oder Poly(vinylpyridin)-Blöcken und/oder Poly(vinylpyrrolidon)-Blöcken und/oder Poly(vinylalkohol)-Blöcken und/oder Poly(ethylenoxid)-Blöcken und/oder Poly(propylenoxid)-Blöcken und/oder Poly(butylmethacrylat)-Blöcken und/oder Poly(N-iso-propylacrylamid)-Blöcken und/oder Poly(dimethylsiloxan)-Blöcken und/oder Polyacrylat-Blöcken und/oder Poly(vinylacetat)-Blöcken und/oder Poly(vinyliden difluorid)-Blöcken und/oder Polythiophen-Blöcken und/oder Poly(styrolsulfonat)-Blöcken,
vii) Copolymeren, die fluorhaltige Comonomere, bevorzugt fluorhaltige Comonomere, die sich aus Fluorethylen, Difluorethylen, Trifluorethylen, Tetrafluorethylen oder Hexafluorpropylen ableiten, enthalten,
viii) leitfähigen und/oder halbleitenden Polymeren,
ix) Polyelektrolyten,
x) Kombinationen aus zwei oder mehreren Polymeren und/oder anorganischen Materialien,
xi) Metallen wie Gold, Silber, Platin, Palladium, Wolfram, Kupfer, Titan, Aluminium, Tantal,
xii) beliebigen Mischungen verschiedener Metalle,
xii) Oxiden, die zumindest ein Metall und Sauerstoff oder zumindest einen Halbleiter und Sauerstoff enthalten, wie etwa Siliziumoxid, Titanoxid, Aluminiumoxid und Tantaloxid,
xiii) anorganischen Halbleitern wie Silizium.

Die Kontaktelemente (2) können mit einer beliebigen Methode zur topographischen Oberflächenstrukturierung erzeugt werden. Ein Beispiel hierfür ist topographische Oberflächenstrukturierung durch fokussierte Ionenstrahlen. Ein weiteres Beispiel ist die lithographische Strukturierung von Schichten aus einem positiven oder negativen Resist, etwa mittels Elektronenstrahllithographie oder mittels optischer Lithographie oder mittels Interferenzlithographie. Diesem lithographischen Strukturierungsschritt folgt die eigentliche topographische Strukturierung zur Erzeugung der Kontaktelemente (2), die beispielsweise durch nasschemisches Ätzen oder durch *reactive ion etching* erfolgen kann.

Eine bevorzugte Methode zur Erzeugung von Kontaktelementen (2) ist das Abformen von Schablonen oder Templaten. Diese Schablonen oder Template weisen eine topographische Struktur auf, die das Negativ der gewünschten topographischen Struktur der Kontaktelemente (2) darstellt und können ihrerseits durch geeignete Kombinationen aus lithographischer und topographischer Strukturierung erzeugt werden. Abformen der Template ergibt somit Kontaktelemente (2) mit der gewünschten Topographie, welche wiederum eine strukturell inverse Kopie der Templat-Topographie ist. Vorteilhaft ist beispielsweise die Verwendung von Templaten aus Elastomer, beispielsweise vemetztem Polydimethylsiloxan oder vernetztem Polyurethan, aus Metall, aus Silicium oder aus anorganischen Oxiden. Ebenso können jedoch Selbstorganisationsprozesse zur Erzeugung der Template genutzt werden. Ein Beispiel für ein Templat, das mittels Selbstorganisation hergestellt wird, ist selbstgeordnetes nanoporöses Aluminiumoxid.^{xix,xx} Durch Abformen von porösem Aluminiumoxid konnten Polymer-Drahtfelder mit Flächen von mehreren cm³ hergestellt werden.^{xxi} Ein weiteres Bespiel für die Erzeugung von Kontaktelementen (2) durch Abformen von durch Selbstorganisation erhaltenen Templaten ist das Abformen von Monolagen aus Nano- oder Mikrokugeln, wobei zur Hochdurchsatzproduktion von monolithischen Kombinationen aus Substrat (1) und Kontaktelementen (2) ein mehrstufiger Abformungsprozess angepasst werden kann, der bereits Stand der Technik ist.^{xxii-xxiv} Dabei lassen sich durch Abformen von Monolagen aus Nano- und Mikrokugeln Mastertemplate aus Elastomer, beispielsweise vemetztem Polydimethylsiloxan oder vernetztem Polyurethan, aus Metall, aus Silicium oder aus anorganischen Oxiden erzeugen, die wiederum zur Erzeugung der Kontaktelemente (2) in weiteren Abformschritten verwendbar sind.

Das Abformen beliebiger Template zur Erzeugung der Kontaktelemente (2) kann auf verschiedene Weise erfolgen. Sollen die monolithischen Kombinationen aus Substrat (1) und Kontaktelementen (2) aus Polymer bestehen, kann das Abformen der Template beispielsweise durch Heißpressen, durch Infiltration von Polymerlösungen oder durch Gasphasenabscheidung von Vorläuferverbindungen des Polymers in das Templat erfolgen. Sollen die monolithischen Kombinationen aus Substrat (1) und Kontaktelementen (2) aus Metall bestehen, können unter anderem elektrochemische Abscheidung, stromlose Abscheidung, Atomlagenabscheidung oder andere Formen der Gasphasenabscheidung eingesetzt werden, um das Templat mit dem gewünschten Metall oder mit geeigneten Vorläuferverbindungen für das gewünschte Metall (die dann in das gewünschte Metall umgewandelt werden) abzuformen. Ebenso kann Infiltration von Mischungen aus einer Vorläuferverbindung des gewünschten Metalls sowie aus Polymeren und/oder strukturdirigierenden Verbindungen wie Tensiden oder Blockcopolymeren als Lösung oder Schmelze in die Template erfolgen, wobei die Vorläuferverbindungen der gewünschten Metalle in die gewünschten Metalle umgewandelt und alle anderen Komponenten der Mischung beispielsweise durch Extraktion oder chemische Zersetzung oder thermische Zersetzung entfernt werden. Sollen die monolithischen Kombinationen aus Substrat (1) und Kontaktelementen (2) aus Oxid bestehen, kann das Templat unter anderem abgeformt werden, indem die Kontaktelemente mittels Sol/Gel-Chemie im Templat oder mittels Thermolyse von geeigneten Vorläuferverbindungen im Templat erzeugt werden. In jedem Fall geht das Substrat (1) aus dem zur Abformung verwendetem Material hervor, das sich auf der Oberfläche des Templates befindet.

Die Kontaktelemente (2) können zylindrische Form aufweisen, wobei die Zylinderachse senkrecht auf der Ebene des Substrates (1) steht oder auch gegen die Oberfläche des Substrates verkippt sein kann. In weiteren vorteilhaften Ausführungsvarianten der monolithischen Kombinationen aus Substrat (1) und Kontaktelementen (2) sind die Kontaktelemente (2) kugelförmig bis halbkugelförmig, rechteckig, quadratisch, pyramidal oder streifenförmig. Es ist jedoch auch vorstellbar, dass die Kontaktelemente jedes beliebige Muster abbilden, das durch lithographische und/oder topographische Strukturierung zugänglich ist. Die dem Substrat (1) abgewandten Enden der Kontaktelemente (2), die in die Nähe der zu bedruckenden Oberfläche (3) gebracht werden, können weiterhin verschiedene Kontaktgeometrien besitzen. Beispielsweise können die Kontaktgeometrien halbkugelförmig (Fig. 2a), pyramidal mit einer auf die zu bedruckende Fläche (3) weisenden Spitze oder eben sein. Ebenso können die Kontaktelemente röhrchenartig ausgeführt sein (Fig. 2b), so dass diese einen durchgehenden zylindrischen Hohlraum aufweisen, durch den Tinte von Substrat (1) zu einer zu bedruckenden Fläche (3) transportiert werden kann.

Vorgesehen ist, das Porensystem in den monolithischen Kombinationen aus Substrat (1) und Kontaktelementen (2) so auszuführen, dass durch dieses den dem Substrat (1) abgewandten Enden der Kontaktelemente (2) Tinte (4) zugeführt werden kann. Beispielsweise können zu diesem Zweck im Porensystem parallel angeordnete zylindrische Poren erzeugt werden. Besonders vorteilhaft ist es jedoch, wenn das Porensystem in allen Raumrichtungen kontinuierlich ist. Beispielsweise können die die poröse Struktur enthaltenden Teilbereiche monolithischer Kombinationen aus Substrat (1) und Kontaktelementen (2) oder aber in Gänze poröse monolithische Kombinationen aus Substrat (1) und Kontaktelementen (2) eine bikontinuierlich-interpenetrierende Morphologie aufweisen, in der das kontinuierliche Porensystem ein Bestandteil ist. Denkbar ist ebenso, das Porensystem von einem Blockcopolymer abzuleiten, welches eine sogenannte gyroide Struktur aufweist. Zur Erzeugung des kontinuierlichen Porensystems in den monolithischen Kombinationen aus Substrat (1) und Kontaktelementen (2) lassen sich unter anderem folgende Methoden einsetzen:
i) Werden als Ausgangsmaterial Mischungen aus zumindest zwei Polymermaterialien oder aus zumindest einem Polymermaterial und zumindest einer weiteren nichtpolymeren Komponente verwendet, kann durch eine Temperaturänderung eine spinodale Entmischung induziert werden, wobei aus der so erhaltenen spinodal entmischten Mischung zumindest eine Komponente beispielsweise durch Extraktion oder durch chemische Zersetzung oder durch thermische Zersetzung entfernt wird.
ii) In Mischungen aus zumindest einem Polymer und zumindest einer verdampfbaren Komponente kann durch Temperaturänderung und/oder durch Verdampfen der verdampfbaren Komponente/n eine spinodale Entmischung induziert werden, wobei durch Verfestigen von zumindest einer polymeren Komponente durch Kristallisation und/oder Verglasung zu einem ausgewählten Zeitpunkt sowie Verdampfung der verdampfbaren Komponente die Porenstruktur erhalten wird.
iii) Werden Blockcopolymere als Ausgangsmaterial verwendet, können kontinuierliche Porensysteme durch Entfernen einer Komponente durch selektives chemisches Zersetzen^{xxv} oder durch quellungsinduzierte Morphologierekonstruktion, wie in xxvi-xxix beschrieben, generiert werden.
iv) Werden Mischungen aus zumindest einem Blockcopolymer und zumindest einer weiteren entfernbaren Kompontente als Ausgangsmaterial verwendet, können kontinuierliche Porensysteme durch Entfernen von zumindest einer weiteren entfernbaren Komponente beispielsweise durch selektives chemisches Zersetzen, durch selektives thermisches Zersetzen oder durch Extraktion generiert werden. Ein Beispiel hierfür ist wasserstoffbrückenbindungsassistierte Selbstorganisation von Blockcopolymeren wie PS-*b*-P2VP und niedermolekularen Additiven wie 3-*n*-pentadecyphenol^{xxx} verbunden mit dem Entfernen des niedermolekularen Additivs.
v) Spinodale Entmischung einer Mischung, die zumindest eine vernetzbare Komponente enthält, kombiniert mit der Vernetzung zumindest einer vernetzbaren Komponente, wobei Poly(styrol-divinylbenzol) ein Beispiel für eine vernetzbare Komponente darstellt.
vi) Präparation eines interpenetrierenden Netzwerks nicht mischbarer Homopolymere und des entsprechenden Blockcopolymers kombiniert mit der Vernetzung eines der Netzwerke und Entfernen des anderen.^{xxxi}
vii) Sollen monolithische Kombinationen aus Substrat (1) und Kontaktelementen (2) aus Metall bestehen, kann eine kontinuierliche Porenstruktur zunächst durch zumindest eine der Methoden i)-vi) erzeugt werden, um diese dann mit Metall abzuformen und anschließend alle anderen Komponenten beispielsweise mittels chemischer Zersetzung, mittels thermischer Zersetzung oder mittels Extraktion zu entfernen. Das Abformen mit Metall kann unter anderem durch elektrochemische Abscheidung, stromlose Abscheidung, Atomlagenabscheidung oder andere Formen der Gasphasenabscheidung erfolgen, um die existierende Porenstruktur mit dem gewünschten Metall oder mit geeigneten Vorläuferverbindungen für das gewünschte Metall (die dann in das gewünschte Metall umgewandelt werden) abzuformen. Ebenso kann das Abformen durch Infiltration von Vorläuferverbindungen für die Metalle oder Mischungen, die derartige Vorläuferverbindungen enthalten, gefolgt von der Umsetzung besagter Vorläuferverbindungen zu den Metallen, aus denen die monolithischen Kombinationen aus Substrat (1) und Kontaktelementen (2) bestehen sollen, erfolgen.
viii) Sollen monolithische Kombinationen aus Substrat (1) und Kontaktelementen (2) aus Metall bestehen, kann in Mischungen aus einer Vorläuferverbindung des gewünschten Metalls und strukturdirigierenden Verbindungen wie Tensiden und/oder amphiphilen Blockcopolymeren die Porenstruktur durch die strukturdirigierende Wirkung der strukturdirigierenden Verbindungen erzeugt werden. Dabei segregieren die Vorläuferverbindungen für das gewünschte Metall zunächst in durch die strukturdirigierenden Verbindungen definierte Kompartimente bestimmter Polarität. Danach erfolgt die Umwandlung der Vorläuferverbindung für das gewünschte Metall in das gewünschte Metall und das Entfernen aller anderen Komponenten durch chemisches Zersetzen und/oder thermisches Zersetzen und/oder Extraktion.
ix) Sollen monolithische Kombinationen aus Substrat (1) und Kontaktelementen (2) aus Metall bestehen, kann in einer Mischung, die zumindest aus einer Vorläuferverbindung für ein Metall und einer weiteren Komponente besteht, durch Temperaturänderung oder Änderung der Zusammensetzung der Mischung eine spinodale Entmischung generiert werden, wobei nach Umwandlung von zumindest einer Vorläuferverbindung für ein Metall in das betreffende Metall alle Komponenten, die nicht Metall oder Metallvorläuferverbindung sind, durch Verdampfen und/oder durch Extraktion und/oder durch thermische Zersetzung und/oder durch chemische Zersetzung entfernt werden.
x) Sollen monolithische Kombinationen aus Substrat (1) und Kontaktelementen (2) aus Metall bestehen, so kann zunächst eine Metall-Legierung eingesetzt werden, die zwei oder mehrere Metalle enthält. Durch Initiierung einer Entmischung und anschließendes Entfernen von zumindest einer der Komponenten der Legierung wird in der verbliebenen Komponente oder in den verbliebenen Komponenten ein Porensystem erzeugt.
xi) Sollen monolithische Kombinationen aus Substrat (1) und Kontaktelementen (2) aus Oxiden bestehen, kann eine kontinuierliche Porenstruktur zunächst durch zumindest eine der Methoden i)-vi) erzeugt werden, um diese dann mit Oxid abzuformen und anschließend alle anderen Komponenten beispielsweise mittels chemischer Zersetzung, mittels thermischer Zersetzung oder mittels Extraktion zu entfernen. Das Abformen mit Oxid kann unter anderem durch Infiltration des vorhandenen Porensystems mit Sol-Lösungen erfolgen, so dass die gewünschten Oxide in den vorhandenen Poren durch Sol-Gel-Chemie erzeugt werden. Ebenso ist es möglich, in das vorhandene Porensystem Lösungen zu infiltrieren, die durch Thermolyse in das gewünschte Oxid umwandelbare Vorläuferverbindungen enthalten. Weiterhin können Vorläuferverbindungen für die gewünschten Oxide mittels Gasphasenabscheidung, bevorzugt Atomlagenabscheidung, in das vorhandene Porensystem abgeschieden werden, wobei die Vorläuferverbindungen mittels einer geeigneten Methode in das gewünschte Oxid umgewandelt werden.
xii) Sollen monolithische Kombinationen aus Substrat (1) und Kontaktelementen (2) aus Oxid bestehen, kann eine Mischung aus zumindest einer Vorläuferverbindung für Oxid und zumindest einer amphiphilen strukturdirigierenden Verbindung, beispielsweise einem Tensid oder einem Blockcoplymer, verwendet werden, in der mittels Sol-Gel-Chemie und/oder Thermolyse zumindest eine Vorläuferverbindung für Oxid in Oxid umgewandelt wird, während die amphiphilen strukturdirigierenden Verbindungen durch Extraktion und/oder durch thermische Zersetzung und/oder durch chemische Zersetzung entfernt werden.

In einer vorteilhaften Ausführungsvariante der Herstellung der monolithischen Kombinationen aus Substrat (1) und Kontaktelementen (2) wird die topographische Strukturierung zur Erzeugung der Kontaktelemente (2) gleichzeitig mit der Erzeugung des kontinuierlichen Porensystems durchgeführt. Zur Erhöhung der Fläche der Porenöffnungen an der Oberfläche der monolithischen Kombinationen aus Substrat (1) und Kontaktelementen (2) kann letztere mit Ätzmethoden wie Sauerstoffplasmabehandlung oder *reactive ion etching* behandelt werden. Röhrchenartige Kontaktelemente, wie in Fig. 2b dargestellt, lassen sich beispielsweise durch Abformung von Templaten mit zylindrischen Templatporen erzeugen, wobei die mit dem Abformen kombinierte Porenbildung so ausgeführt wird, dass die zu Porenbildung führenden Strukturbildungsprozesse durch Grenzflächenwechselwirkungen mit den Templatporen dominiert werden.

Ein Merkmal einer technischen Vorrichtung für Kapillar-Nanodruck ist, dass durch die kontinuierlichen Porensysteme der monolithischen Kombinationen aus Substrat (1) und Kontaktelementen (2) je nach Erfordernis entweder kontinuierlich oder schubweise Tinte an die Kontaktelemente (2) herangeführt werden kann. Hierfür ist nicht notwendigerweise eine aktiv generierte Druckdifferenz innerhalb der Tinte erforderlich. Vielmehr kann das Substrat (1) in Kontakt mit einem Tintenreservoir gebracht werden, mit dem Substrat (1) entweder seitlich verbunden ist oder dass sich in Kontakt mit der den Kontaktelementen (2) abgewandten Unterseite des Substrates (1) befindet. In einer vorteilhaften Ausführungsvariante der technischen Vorrichtung für Kapillar-Nanodruck ist die den Kontaktelementen (2) abgewandte Seite des Substrats (1) mit einer weiteren porösen Schicht verbunden, die ganz oder in Teilbereichen mit Tinte vollgesaugt ist und als Tintenreservoir dient. Besagte poröse Schicht kann ganz oder in Teilbereichen aus zumindest einer Komponente bestehen, die ausgewählt ist aus Papier und/oder Zellstoff und/oder Cellulose-haltigen Materialien und/oder Faser-Matten und/oder Schüttungen aus Fasern und/oder Schüttungen aus Kugeln und/oder Schüttungen aus nichtkugelförmigen diskreten Partikeln und/oder Gespinsten und/oder Filzen und/oder elektrogesponnenen Fasermatten und/oder Geweben aller Art und/oder Sand und/oder Schäumen und/oder Gelen wie Aerogelen oder Xerogelen. In einer vorteilhaften Ausführungsvariante der technischen Vorrichtung für Kapillar-Nanodruck erfolgt die Heranführung der Tinte an die Kontaktelemente (2) und das Wiederauffüllen der monolithischen Kombinationen aus Substrat (1) und Kontaktelementen (2) ausschließlich passiv über Kapillarkräfte. Es ist jedoch auch möglich, zusätzliche Komponenten in die technische Vorrichtung für Kapillar-Nanodruck zu integrierten, die aktiven Transport von Tinte zu den Kontaktelementen (2) durch Erzeugung eines Tintenflusses oder einer Druckdifferenz in der Tinte ermöglichen. Ein Beispiel für eine derartige weitere Komponente ist eine Schlauchpumpe.

Die monolithische Kombination aus Substrat (1) und Kontaktelementen (2) (gegebenenfalls in Kombination mit einer weiteren porösen Schicht) kann so ausgeführt sein, dass diese in ihrer Gesamtheit planar ist. Die monolithische Kombination aus Substrat (1) und Kontaktelementen (2) (gegebenenfalls in Kombination mit einer weiteren porösen Schicht) kann ebenso in ihrer Gesamtheit oder zumindest in Teilbereichen gekrümmt sein. Weiterhin kann die Steifigkeit der monolithischen Kombination aus Substrat (1) und Kontaktelementen (2) (gegebenenfalls in Kombination mit einer weiteren porösen Schicht) den technischen Erfordernissen entsprechend eingestellt werden. So kann es vorteilhaft sein, wenn die monolithische Kombination aus Substrat (1) und Kontaktelementen (2) (gegebenenfalls in Kombination mit einer weiteren porösen Schicht) nachgiebig ist, da diese sich dann einer möglicherweise vorhandenen Rauigkeit der zu bedruckenden Fläche (3) derart anpassen kann, dass trotz der Rauigkeit der zu bedruckenden Fläche (3) alle Kontaktelemente (2) Kontakt zur zu bedruckenden Fläche (3) bilden können. Um die Anpassungsfähigkeit einer technischen Vorrichtung für Kapillar-Nanodruck an eine raue zu bedruckende Fläche (3) einstellen zu können, kann die monolithische Kombination aus Substrat (1) und Kontaktelementen (2) (gegebenenfalls in Kombination mit einer weiteren porösen Schicht) in eine Multischichtstruktur integriert werden. Eine vorteilhafte Ausführungsvariante einer derartigen Multischichtstruktur beinhaltet eine dünne, steifere monolithische Kombination aus Substrat (1) und Kontaktelementen (2), die in Kontakt mit einer weichen und optional porösen Stützschicht ist. Während die Steifigkeit der monolithischen Kombination aus Substrat (1) und Kontaktelementen (2) die mechanische Stabilität der Kontaktelemente (2) lokal gewährleistet, ermöglicht die weiche Stützschicht die Anpassung an der Rauigkeit der zu bedruckenden Fläche (3), so dass die Kontaktbildung zwischen Kontaktelementen (2) und zu bedruckender Fläche (3) verbessert wird.

Technische Vorrichtungen für Kapillar-Nanodruck können in verschiedenen technischen Ausführungsvarianten realisiert werden. Fig. 3 stellt eine beispielhafte Ausführungsvariante dar, die für kontinuierlichen Rollenbetrieb konfiguriert ist. Die monolithische Kombination aus Substrat (1) und Kontaktelementen (2) ist Bestandteil einer Rolle. Durch eine Rotationsbewegung der Rolle mit der Kombination aus Substrat (1) und Kontaktelementen (2) kann eine Fläche (3), die mit einer der Rotationsgeschwindigkeit der Rolle angepassten Geschwindigkeit an der Rolle vorbeigeführt wird, mit Tintentropfen (5) bedruckt werden.

Die Rolle kann vollständig aus der monolithischen Kombination aus Substrat (1) und Kontaktelementen (2) bestehen. In diesem Fall ist das Substrat (1) als Zylinder ausgeführt, der an seiner äußeren Oberfläche die Kontaktelemente (2) aufweist. Um den Kontaktelementen (2) an Rollenkonstruktionen, die vollständig aus monolithischen Kombinationen aus Substrat (1) und Kontaktelementen (2) bestehen, über das Substrat (1) kontinuierlich oder diskontinuierlich kontrolliert Tinte zuzuführen, sind verschiedene Varianten für die Beschickung besagter Rollenkonstruktion mit Tinte denkbar. Ist die Längsachse besagter Rollenkonstruktion horizontal angeordnet, kann die Rollenkonstruktion ganz oder in Teilbereichen kontinuierlich oder während ausgewählter Zeitintervalle mit Tinte beschickt werden. Die Beschickung mit Tinte kann, während die Rollenkonstruktion mit ihrer Betriebswinkelgeschwindigkeit um ihre Längsachse rotiert, an zumindest einem Segment der Rollenkonstruktion erfolgen, das nicht in Kontakt mit der zu bedruckenden Fläche (3) kommt und/oder an zumindest einem Segment der Rollenkonstruktion, das in Kontakt mit der zu bedruckenden Fläche (3) kommt. Das Beschicken besagter Rollenkonstruktion mit Tinte kann beispielsweise mittels Beträufeln erfolgen. Ist die Längsachse besagter Rollenkonstruktion vertikal angeordnet, kann der untere Teil der Rollenkonstruktion während des kontinuierlichen Rollenbetriebs in ein Tintenreservoir eintauchen, während die zu bedruckende Fläche (3) nur mit dem oberen Teil der Rollenkonstruktion in Kontakt kommt.

Die Rolle kann aber neben der monolithischen Kombination aus Substrat (1) und Kontaktelementen (2) auch weitere Komponenten beinhalten. Beispielsweise kann eine Rollenkonstruktion neben einem zylindermantelförmig ausgeführten Substrat (1), welches die äußere zylindrische Oberfläche der Rollenkonstruktion bildet und welches mit Kontaktelementen (2) bestückt ist, einen Rollenkern aus zumindest einer weiteren Komponente enthalten, wobei Substrat (1) besagten Rollenkern umschließt. Weitere, in besagtem Rollenkern enthaltene Komponenten können ihrerseits als Zylinder oder als Zylindermantel ausgeführt sein. In einer vorteilhaften Ausführungsvariante enthält der Rollenkern zumindest eine Komponente, die aus zumindest einer weiteren porösen Schicht besteht oder die zumindest in Teilbereichen zumindest eine weitere poröse Schicht aufweist. Besagte poröse Schicht kann ganz oder in Teilbereichen aus zumindest einer Komponente bestehen, die ausgewählt ist aus Papier und/oder Zellstoff und/oder Cellulose-haltigen Materialien und/oder Faser-Matten und/oder Schüttungen aus Fasern und/oder Schüttungen aus Kugeln und/oder Schüttungen aus nichtkugelförmigen diskreten Partikeln und/oder Gespinsten und/oder Filzen und/oder elektrogesponnenen Fasermatten und/oder Geweben aller Art und/oder Sand und/oder Schäumen und/oder Gelen wie Aerogelen oder Xerogelen. In einer vorteilhaften Ausführungsvariante der Rollenkonstruktion schießt das zylindermantelförmige Substrat (1) derart an die weitere poröse Schicht an, dass Tinte von der weiteren porösen Schicht über das Substrat (1) zu den Kontaktelementen (2) gelangen kann. Eine vorteilhafte technische Lösung zur Zuführung von Tinte in eine derartige Rollenkonstruktion beinhaltet, dass die weitere poröse Schicht zumindest teilweise unter der zylindermantelförmig ausgeführten monolithischen Kombination aus Substrat (1) und Kontaktelementen (2) herausragt. Ist die Längsachse der Rollenkonstruktion horizontal angeordnet, kann der herausragende Teil der besagten weiteren porösen Schicht ganz oder in Teilbereichen kontinuierlich oder während ausgewählter Zeitintervalle mit Tinte beschickt werden. Die Beschickung mit Tinte kann, während die Rollenkonstruktion mit ihrer Betriebswinkelgeschwindigkeit um ihre Längsachse rotiert, an zumindest einem Segment der Rollenkonstruktion erfolgen, das nicht in Kontakt mit der zu bedruckenden Fläche (3) kommt. Das Beschicken besagter Rollenkonstruktion mit Tinte kann beispielsweise mittels Beträufeln erfolgen. Ist die Längsachse besagter Rollenkonstruktion vertikal angeordnet und ragt die weitere poröse Schicht unter der als Zylindermantel ausgeführten und an die weitere poröse Schicht nach außen anschließenden monolithischen Kombination aus Substrat (1) und Kontaktelementen (2) nach unten heraus, kann der besagte herausragende Teil der weiteren porösen Schicht während des kontinuierlichen Rollenbetriebs in ein im unteren Teil der Rollenkonstruktion befindliches Tintenreservoir eintauchen.

Eine weitere vorteilhafte Ausführungsvariante des Kapillar-Nanodrucks ist der Batch-Betrieb. In dieser Ausführungsvariante ist die monolithische Kombination aus Substrat (1) und Kontaktelementen (2) in eine technische Vorrichtung zur Durchführung von Kapillar-Nanodruck integriert, die eine kontrollierte Annäherung von Kontaktelementen (2) und zu bedruckender Fläche (3) aneinander und nach erfolgtem Tintentransfer die kontrollierte Vergrößerung des Abstandes zwischen Kontaktelementen (2) und mit Tintentropfen (5) bedruckter Fläche (3) erlaubt. Anschließend kann ein weiterer Druckzyklus anschließen, in dem entweder eine weitere, noch nicht bedruckte Fläche (3) mit Tinte bedruckt wird oder in dem eine bereits mit Tinte bedruckte Fläche (3) ein weiteres Mal bedruckt wird. Zu diesem Zweck kann die technische Vorrichtung zur Durchführung von Kapillarnanodruck mit einer Vorrichtung kombiniert werden, die die zu bedruckende Flächen relativ zur monolithischen Kombination aus Substrat (1) und Kontaktelementen (2) positioniert oder die die monolithische Kombination aus Substrat (1) und Kontaktelementen (2) relativ zu den zu bedruckenden Flächen positioniert.

Je nach technischen Erfordernissen lässt sich eine technische Vorrichtung zur Durchführung des Kapillar-Nanodrucks unabhängig vom vorgesehenen Betriebsmodus (etwa Batch-Betrieb oder kontinuierlicher Rollenbetrieb) mit einzelnen vorteilhaften Ausstattungs- und Leistungsmerkmalen oder mit beliebigen Kombinationen vorteilhafter Ausstattungs- und Leistungsmerkmale versehen. Beispiele für vorteilhafte Ausstattungs- und Leistungsmerkmale, die sich auch beliebig miteinander kombinieren lassen, sind:
i) Automatisierte Heranführung der zu bedruckenden Fläche (3) an die Felder der Kontaktelemente (2). Dabei kann der zu bedruckende Ausschnitt der zu bedruckenden Fläche (3) oder aber die monolithische Kombination aus Substrat (1) und Kontaktelementen (2) so positioniert werden, dass innerhalb eines Druckzyklus der gewünschte Bereich der Fläche (3) bedruckt wird. Ebenso ist vorstellbar, dass die zu bedruckende Fläche (3) in Form diskreter Schnitte oder diskreter Teile vorliegt. In diesem Fall können entweder die diskreten Schnitte beziehungsweise Teile (3) automatisch so positioniert werden, dass diese in Kontakt mit den Kontaktelementen (2) gebracht werden können. Dies kann beispielsweise mittels einer fließbandartigen Einrichtung erreicht werden. Selbstverständlich sind auch Ausführungsvarianten vorstellbar, die die Positionierung nicht der zu bedruckenden Flächen (3), sondern der monolithischen Kombination aus Substrat (1) und Kontaktelementen (2) vorsehen.
ii) Eine Vorrichtung zur Kontrolle der Atmosphäre, in der der Prozess des Kapillar-Nanodruckens durchgeführt wird. Beispielsweise kann es vorteilhaft sein, die Luftfeuchtigkeit während des Kapillar-Nanodrucks gezielt einstellen zu können oder Kapillar-Nanodruck unter Inertgas-Atmosphäre durchführen zu können.
iii) Die Ausführung der technischen Vorrichtung zur Durchführung von Kapillar-Nanodruck derart, dass verschiedene monolithische Kombinationen aus Substrat (1) und Kontaktelementen (2) leicht gegeneinander austauschbar sind.
iv) Das Möglichkeit zur Durchführung von Reinigungszyklen zur Entfernung von Tintenresten und anderen Kontaminationen, indem beispielsweise die monolithischen Kombinationen aus Substrat (1) und Kontaktelementen (2) sowie andere Komponenten der technischen Vorrichtung zur Durchführung von Kapillar-Nanodruck in Reinigungsbäder eingetaucht werden oder indem Reinigungsfluide (Gase oder Flüssigkeiten) durch die zu reinigenden Komponenten der technischen Vorrichtung zur Durchführung von Kapillarnanodruck geleitet werden.
v) Ein System zur präzisen Steuerung und Kontrolle der Annäherung der Kontaktelemente (2) und der zu bedruckenden Fläche (3) aneinander sowie zur präzisen Steuerung und Kontrolle des Trennens der Kontaktelemente (2) und der bedruckten Fläche (3) voneinander. In einer vorteilhaften Ausführungsvariante dieses Steuerungs- und Kontrollsystems kann der Abstand zwischen den Kontaktelementen (2) und zu bedruckender Fläche (3) mit einer Genauigkeit von bevorzugt besser als 30 nm, besonders bevorzugt besser als 10 nm und am meisten bevorzugt besser als 2 nm eingestellt werden. Weiterhin ist es vorteilhaft, wenn sich Annäherungs- und Trennungsgeschwindigkeiten mit hoher Präzision, bevorzugt mit einer Präzision besser 1 µm/s, besonders bevorzugt besser 100 nm/s und am meisten bevorzugt besser 10 nm/s einstellen lassen. In einer vorteilhaften Ausführungsvariante von technischen Vorrichtungen zur Durchführung von Kapillar-Nanodruck kann die Annäherung der Kontaktelemente (2) an die zu bedruckende Fläche (3) gestoppt werden, sobald sich Kapillarbrücken aus Tinte (4) zwischen den Kontaktelementen (2) und der zu bedruckenden Fläche (3) ausgebildet haben. Diese Art der Kontaktbildung kann beispielsweise durch Detektion der zur Annäherung erforderlichen Kraft erfolgen, wobei eine Zunahme dieser Kraft bei weiterer Annäherung Kontaktbildung anzeigt. Denkbar ist ebenso, dass Kontaktbildung durch Schließen elektrischer Kontakte zwischen der monolithischen Kombination aus Substrat (1) und Kontaktelementen (2) sowie der zu bedruckenden Fläche (3) angezeigt wird.
vi) In einer vorteilhaften Ausführungsvariante weisen technische Vorrichtungen zur Durchführung von Kapillar-Nanodruck Vorrichtungen auf, die die Herstellung von Kontakt zwischen Kontaktelementen (2) und zu bedruckender Fläche (3) kenntlich machen. Eine vorteilhafte Ausführungsvariante einer Vorrichtung, die die Herstellung von Kontakt zwischen Kontaktelementen (2) und zu bedruckender Fläche (3) kenntlich macht, beruht auf der Herstellung eines elektrischen Kontaktes zwischen Kontaktelementen (2) und zu bedruckender Fläche (3). Eine beispielhafte Ausführungsvariante beinhaltet die Verwendung von monolithischen Kombinationen aus Substrat (1) und Kontaktelementen (2), die zumindest in Teilbereichen elektrische Leitfähigkeit aufweisen. Derartige Leitfähigkeit kann beispielsweise durch Beschichten zumindest von Teilbereichen monolithischer Kombinationen aus Substrat (1) und Kontaktelementen (2) mit leitfähigem Material, durch Abscheidung von leitfähigem Material in die Poren der monolithischen Kombinationen aus Substrat (1) und Kontaktelementen (2) zumindest in Teilbereichen der monolithischen Kombinationen aus Substrat (1) und Kontaktelementen (2), oder durch Verwendung monolithischer Kombinationen aus Substrat (1) und Kontaktelementen (2), die zumindest in Teilbereichen zumindest ein elektrisch leitfähiges Material enthalten, erreicht werden. Weiterhin kann die zu bedruckende Fläche (3) zumindest in Teilbereichen mit leitfähigem Material derart beschichtet werden, dass leitfähige Bereiche der monolithischen Kombinationen aus Substrat (1) und Kontaktelementen (2) sowie leitfähige Bereiche der zu bedruckenden Fläche (3) bei Kontaktbildung zwischen monolithischer Kombination aus Substrat (1) und Kontaktelementen (2) sowie der zu bedruckenden Fläche (3) elektrisch leitenden Kontakt bilden.
vii) In einer vorteilhaften Ausführungsvariante weisen technische Vorrichtungen zur Durchführung von Kapillar-Nanodruck flexible Aufhängungen für die monolithischen Kombinationen aus Substrat (1) und Kontaktelementen (2) und/oder für die zu bedruckenden Fläche (3) auf. Derartige flexible Aufhängungen für die monolithischen Kombinationen aus Substrat (1) und Kontaktelementen (2) und/oder für die zu bedruckenden Flächen (3) lösen das technische Problem, dass aufgrund nicht exakt koplanarer Ausrichtung der monolithischen Kombinationen aus Substrat (1) und Kontaktelementen (2) sowie der zu bedruckenden Fläche (3) zueinander die Kontaktbildung zwischen Kotaktelementen (2) und zu bedruckender Fläche (3) nicht korrekt erfolgt.
viii) Ein weiteres vorteilhaftes Ausstattungs- und Leistungsmerkmal der technischen Vorrichtung zur Durchführung von Kapillarnanodruck kann das Bereitstellen einer elastischen Schicht sein, die mit der monolithischen Kombination aus Substrat (1) und Kontaktelementen (2) auf der den Kontaktelementen (2) abgewandten Seite des Substrats (1) in Kontakt gebracht wird. Eine koplanare Ausrichtung der monolithischen Kombination aus Substrat (1) und Kontaktelementen (2) zur zu bedruckenden Fläche (3) ebenso wie eine Adaption der monolithischen Kombination aus Substrat (1) und Kontaktelementen (2) an Rauigkeiten auf der zu bedruckenden Fläche (3) kann dann durch elastische Deformation der besagten elastischen Schicht erfolgen.
ix) Ein weiteres vorteilhaftes Ausstattungs- und Leistungsmerkmal technischer Vorrichtungen zur Durchführung von Kapillar-Nanodruck ist die Möglichkeit, während des Kapillar-Nanodrucks die Temperatur entweder der gesamten Einheit aus Tintenvorrats- und Bereitstellungssystem, monolithischer Kombination aus Substrat (1) und Kontaktelementen (2) sowie zu bedruckender Fläche (3) oder von Teilbereichen hiervon einstellen zu können. Besonders vorteilhaft sind hierbei Ausführungsvarianten, die die Einstellung spezifischer Temperaturen zumindest in Teilbereichen von Tintenvorrats- und Bereitstellungssystem, monolithischer Kombination aus Substrat (1) und Kontaktelementen (2) sowie zu bedruckender Fläche (3) jeweils unabhängig voneinander erlauben, so dass zumindest in Teilbereichen technischer Vorrichtungen zur Durchführung von Kapillar-Nanodruck gezielt Temperaturdifferenzen erzeugt werden können. Weiterhin vorteilhaft ist die Möglichkeit, jeweils innerhalb von monolithischen Kombinationen aus Substrat (1) und Kontaktelementen (2) und/oder zu bedruckender Fläche (3) zumindest in Teilbereichen Temperaturdifferenzen zu realisieren. Geeignete Komponenten zum Heizen und/oder Kühlen, die in technische Vorrichtungen zur Durchführung von Kapillar-Nanodruck integriert werden können, sind beispielsweise Heizpatronen oder Peltier-Elemente.
x) Ein weiteres vorteilhaftes Ausstattungs- und Leistungsmerkmal von Einrichtungen zur Durchführung von Kapillar-Nanodruck ist die Möglichkeit, Kapillar-Nanodruck in Gegenwart elektrischer Felder durchzuführen. Beispielhafte Vorteile sind die Erzeugung bestimmter Oberflächenladungen auf den Wänden des kontinuierlichen Porensystems der monolithischen Kombinationen aus Substrat (1) und Kontaktelementen (2), Steuerung des Tintentransports mittels elektrischer Felder oder die Kombination von Kapillar-Nanodruck mit elektrochemischen Prozessen. Vorteilhafte Realisierungsformen von elektrischen Feldern zumindest in Teilbereichen von Vorrichtungen zur Durchführung von Kapillar-Nanodruck beinhalten die Erzeugung elektrischer Felder zwischen monolithischer Kombination aus Substrat (1) und Kontaktelementen (2) sowie zu bedruckender Fläche (3). Es kann auch vorteilhaft sein, innerhalb der monolithischen Kombination aus Substrat (1) und Kontaktelementen (2) und/oder innerhalb der zu bedruckenden Fläche (3) ein elektrisches Feld anzulegen, wobei dieses elektrische Feld beliebige Orientierungen besitzen kann, die jedoch anhand der Erfordernisse der technischen Anwendung gezielt ausgewählt werden. Eine besonders vorteilhafte Ausführungsvariante des Kapillar-Nanodrucks beinhaltet die Kontrolle der Form der gedruckten Tintentropfen (5) auf der bedruckten Fläche (3) durch Ausnutzung von Elektrowetting-Phänomenen.
xi) Ein weiteres vorteilhaftes Ausstattungs- und Leistungsmerkmal von Einrichtungen zur Durchführung von Kapillar-Nanodruck ist die Möglichkeit, Kapillar-Nanodruck in Gegenwart magnetischer Felder durchzuführen.

Kapillar-Nanodruck führt jeweils an den Positionen der Kontaktelemente (2) zur Abscheidung von Tintentropfen (5) auf der zu bedruckenden Fläche (3). Dabei erfolgt der Transfer der Tinte (4) von den mit Tinte gefüllten Kontaktelementen (2) zur zu bedruckenden Fläche (3) über Kapillarbrücken aus Tinte (4) (siehe Fig. 1). Abhängig von der Art und Weise, wie die Kapillarbrücken aus Tinte (4) beim Trennen der Kontaktelemente (2) von der bedruckten Fläche (3) brechen, können die auf der bedruckten Fläche (3) abgeschiedenen Tintentropfen (5) wesentlich kleinere Dimensionen aufweisen als die Kontaktelemente (2). Ein typisches Beispiel für eine technische Vorrichtungen zur Durchrührung von Kapillar-Nanodruck weist hexagonale Arrays von Kontaktelementen (2) mit Durchmessern von ~60 nm, nächster-Nachbar-Abständen von ~100 nm und Flächendichten von ~130 Kontaktelementen (2) pro µm² auf einer Gesamtfläche von 9 cm² auf. Die Verwendung dieser beispielhaften Vorrichtung zur Durchführung von Kapillar-Nanodruck führt somit zur Abscheidung von diskreten Tintentropfen (5) mit Volumina bis herab zu 10 Zeptolitern, die über eine Fläche von 9 cm² ein hexagonales Array mit nächster-Nachbar-Abständen von ~100 nm und Flächendichten von ~130 Tintentropfen (5) pro µm² bilden. Mittels der verschiedenen Ausführungsvarianten von Kapillar-Nanodruck lässt sich ein breites Spektrum verschiedener Tinten verdrucken. Im Prinzip kann jede fließfähige Flüssigkeit aus einem Reinstoff oder aus einer Mischung von mehreren Stoffen und/oder Komponenten, sei es eine Schmelze, eine Mischung, eine Lösung, eine Emulsion, eine Suspension oder eine ionische Flüssigkeit, verdruckt werden. Es ist denkbar, dass die Tinte mit der Oberfläche der zu bedruckenden Fläche (3) spezielle Wechselwirkungen eingeht oder dass die Tinte (4) an der Oberfläche der zu bedruckenden Fläche (3) spezifische chemische Reaktionen vollführt, und dass auf diese Weise die Form der Tintentropfen (5) gezielt beeinflusst wird. Tinten (4), die mit zumindest einer Ausführungsvariante des Kapillar-Nanodrucks verdruckbar sind, können insbesondere ausgewählt sein oder beliebige Kombinationen bilden aus:
i) Flüssigkeiten, Schmelzen, Mischungen, Lösungen, Emulsionen, Suspensionen oder ionischen Flüssigkeiten, die zumindest Nanopartikel mit Durchmessern von 1 nm bis 500 nm enthalten, die wiederum zumindest eine oder eine beliebige Kombination folgender Eigenschaften aufweisen: Die Nanopartikel bestehen aus Halbleitern und/oder die Nanopartikel bestehen aus Metall und/oder die Nanopartikel bestehen aus Oxid und/oder die Nanopartikel bestehen aus organischen Liganden an einem anorganischen Kern und/oder die Nanopartikel bestehen aus beliebigen Kombinationen von Halbleitern, Metallen, Oxiden und organischen Liganden und/oder die Nanopartikel bestehen aus mehreren Schichten aus verschiedenen Materialien ausgewählt aus Halbleitern, Metallen, Oxiden und organischen Liganden und/oder die Nanopartikel sind magnetisch oder magnetisierbar und/oder die Nanopartikel sind ferroelektrisch und/oder die Nanopartikel zeigen Fluoreszenz und/oder die Nanopartikel zeigen Lichtemission im Wellenlängenbereich von 100 nm bis 10 µm und/oder die Nanopartikel zeigen Plasmonenabsorption und/oder an die Nanopartikel gebundene Liganden oder in unmittelbarer Nähe der Nanopartikeloberfläche befindliche Verbindungen zeigen oberflächenverstärkte Ramanstreuung (SERS) und/oder die Nanopartikel zeigen Aufkonversion von elektromagnetischer Strahlung und/oder die Nanopartikel zeigen *downconversion* von elektromagnetischer Strahlung und/oder die Nanopartikel zeigen Spinpolarisation oder Spinpolarisierbarkeit.
ii) Flüssigkeiten, Schmelzen, Mischungen, Lösungen, Emulsionen, Suspensionen oder ionischen Flüssigkeiten, die zumindest ein polymeres Material oder eine beliebige Kombinationen polymerer Materialien enthalten, wobei besagte polymere Materialien unter anderem ausgewählt sein können aus
   - organischen Polymeren wie Poly(p-xylylen), Polyacrylamid, Polyimiden, Polyestern, Polyolefinen, Polystyrolen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polyethylenen,
   - fluorhaltigen Polymeren wie Polyvinylidenfluorid, Polytrifluorethylen, Polytretrafluorethylen, Polyhexafluorpropylen,
   - biologischen Polymeren wie Polysacchariden, Cellulose (modifiziert oder nichtmodifiziert), Alginaten, Polypeptiden, Collagen, DNA, RNA,
   - Polymeren, die aus mindestens zwei verschiedenen Wiederholungseinheiten aufgebaut sind, bevorzugt in Form von statistischen Copolymeren, Blockcopolymeren, Propfcopolymeren, Dendrimeren,
   - Copolymeren, die fluorhaltige Comonomere, bevorzugt fluorhaltige Comonomere, die sich aus Fluorethylen, Difluorethylen, Trifluorethylen, Tetrafluorethylen oder Hexafluorpropylen ableiten, enthalten,
   - Dendrimeren
   - leitfähigen und halbleitenden Polymeren.
iii) Flüssigkeiten, Schmelzen, Mischungen, Lösungen, Emulsionen, Suspensionen oder ionischen Flüssigkeiten, die zumindest ein Monomer oder beliebige Kombinationen von Monomeren polymerer Materialien enthalten, wobei besagte Monomere unter anderem ausgewählt sein können aus Monomeren für
   - organische Polymere wie Poly(p-xylylen), Polyacrylamid, Polyimiden, Polyestern, Polyolefinen, Polystyrolen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polyethylenen,
   - fluorhaltige Polymere wie Polyvinylidenfluorid, Polytrifluorethylen, Polytretrafluorethylen, Polyhexafluorpropylen,
   - biologische Polymere wie Polysacchariden, Cellulose (modifiziert oder nichtmodifiziert), Alginaten, Polypeptiden, Collagen, DNA, RNA,
   - Dendrimere
   - leitfähige und halbleitende Polymere.
iv) Flüssigkeiten, Schmelzen, Mischungen, Lösungen, Emulsionen oder Suspensionen, die zumindest eine ionische Flüssigkeit aufweisen.
v) Flüssigkeiten, Schmelzen, Mischungen, Lösungen, Emulsionen, Suspensionen oder ionischen Flüssigkeiten, die zumindest eine photovernetzbare Komponente aufweisen.
vi) Flüssigkeiten, Schmelzen, Mischungen, Lösungen, Emulsionen, Suspensionen oder ionischen Flüssigkeiten, die zumindest eine thermisch vernetzbare Komponente aufweisen.
vii) Flüssigkeiten, Schmelzen, Mischungen, Lösungen, Emulsionen, Suspensionen oder ionischen Flüssigkeiten, die zumindest eine Säure enthalten.
viii) Flüssigkeiten, Schmelzen, Mischungen, Lösungen, Emulsionen, Suspensionen oder ionischen Flüssigkeiten, die zumindest eine Base enthalten.
ix) Flüssigkeiten, Schmelzen, Mischungen, Lösungen, Emulsionen, Suspensionen oder ionischen Flüssigkeiten, die zumindest eine Verbindung enthalten, die über eine Ankergruppe an die zu bedruckende Oberfläche binden kann, wobei besagte Ankergruppe unter anderem ausgewählt sein kann aus Thiol-Gruppen, Silan-Gruppen, Halogensilan-Gruppen, Alkoxysilan-Gruppen, Phosphonat-Gruppen und 1-Alkyl-Gruppen.
x) Flüssigkeiten, Schmelzen, Mischungen, Lösungen, Emulsionen, Suspensionen oder ionischen Flüssigkeiten, die zumindest eine Komponente enthalten, die auf der zu bedruckenden Oberfläche (3) SAMs ("*self*-*assembled monolayers*") bilden kann.
xi) Flüssigkeiten, Schmelzen, Mischungen, Lösungen, Emulsionen, Suspensionen oder ionischen Flüssigkeiten, die zumindest eine Komponente enthalten, die zumindest zwei funktionelle Gruppen enthält, wobei bevorzugt eine der besagten funktionellen Gruppen an Fläche (3) binden kann und zumindest eine weitere der besagten funktionellen Gruppen die Immobilisierung von weiteren Verbindungen und/oder chemische Funktionalisierung erlaubt und wobei besagte Gruppen vorzugsweise ausgewählt sind aus Alkyl-Gruppen, Derivaten von Alkyl-Gruppen, Alkenyl-Gruppen, Alkinyl-Gruppen, Phenyl-Gruppen, Derivaten von Phenyl-Gruppen, Halogenalkyl-Gruppen, Halogenaryl-Gruppen, Hydroxyl-Gruppen, CarbonylGruppen, Aldehyd-Gruppen, Carboxyl-Gruppen, Keto-Gruppen, Carbonat-Gruppen, EtherGruppen, Ester-Gruppen, Alkoxy-Gruppen, Peroxo-Gruppen, Acetal-Gruppen, Halbacetal-Gruppen, Amino-Gruppen, Amido-Gruppen, Imino-Gruppen, Imido-Gruppen, Azido-Gruppen, Azo-Gruppen, Cyanat-Gruppen, Nitrat-Gruppen, Nitrilo-Gruppen, Nitrito-Gruppen, Nitro-Gruppen, Nitroso-Gruppen, Pyridino-Gruppen, Thiol-Gruppen, Sulfid-Gruppen, Disulfid-Gruppen, Sulfoxid-Gruppen, Sulfonyl-Gruppen, Sulfino-Gruppen, Sulfo-Gruppen, Thiocynanat-Gruppen, Sulfat-Gruppen, Sulfonat-Gruppen, Phosphin-Gruppen, Phosphonat-Gruppen und/oder Phosphat-Gruppen.
xii) Sol-Gel-Formulierungen, bevorzugt Sol-Gel-Formulierungen, die zumindest eine der folgenden Komponenten oder beliebige Kombinationen folgender Komponenten enthalten: Vorläuferverbindungen für Siliziumoxid, Vorläuferverbindungen für Titanoxid, Vorläuferverbindungen für Aluminiumoxid, Vorläuferverbindungen für Tantaloxid, Vorläuferverbindungen für Oxide von Halbleitern oder Metallen, Vorläuferverbindungen für amorphe oder in Teilbereichen kristalline oder vollständig kristalline Kohlenstoffmaterialien, Tenside, amphiphile Blockcopolymere.
xiii) Flüssigkeiten, Schmelzen, Mischungen, Lösungen, Emulsionen, Suspensionen oder ionischen Flüssigkeiten, die zumindest eine Vorläuferverbindung für ein Metall enthalten, welches unter anderem ausgewählt sein kann aus Gold, Silber, Platin, Palladium, Wolfram, Kupfer, Titan, Aluminium, Tantal.
xiv) Flüssigkeiten, Schmelzen, Mischungen, Lösungen, Emulsionen, Suspensionen oder ionischen Flüssigkeiten, die zumindest eine Vorläuferverbindung für anorganische Oxide enthalten, wobei besagte anorganische Oxide unter anderem ausgewählt sein können aus Siliziumoxid, Titanoxid, Aluminiumoxid und Tantaloxid.
xv) Flüssigkeiten, Schmelzen, Mischungen, Lösungen, Emulsionen, Suspensionen oder ionischen Flüssigkeiten, die zumindest eine Vorläuferverbindung für amorphe oder in Teilbereichen kristalline oder vollständig kristalline Kohlenstoffmaterialien enthalten.
xvi) Flüssigkeiten, Schmelzen, Mischungen, Lösungen, Emulsionen, Suspensionen oder ionischen Flüssigkeiten, die Affinitäts-Tags und/oder Antikörper und/oder Antigene und/oder DNA und/oder RNA enthalten.
xvii) Flüssigkeiten, Schmelzen, Mischungen, Lösungen, Emulsionen, Suspensionen oder ionischen Flüssigkeiten, die in ihrem flüssigen und/oder verfestigten Zustand durch Einwirkung von elektromagnetischer Strahlung und/oder von elektrischen Feldern und/oder von magnetischen Feldern und/oder durch Einwirkung von Phononen in zumindest einer ihrer Eigenschaften reversibel und/oder irreversibel verändert werden können.

Die durch Kapillar-Nanodruck auf eine bedruckte Fläche (3) aufgebrachte Tinte (5) kann unter anderem durch zumindest eine der folgenden Methoden oder beliebige Kombinationen folgender Methoden verfestigt werden:
i) Kristallisation von zumindest einer in der Tinte enthaltenen kristallisationsfähigen Komponente.
ii) Verglasung von zumindest einer in der Tinte enthaltenen glasbildenden Komponente.
iii) Verdampfung von zumindest einer in der Tinte enthaltenen flüchtigen Komponente.
iv) Photovernetzung von zumindest einer in der Tinte enthaltenen photovernetzbaren Komponente.
v) Thermische Vernetzung von zumindest einer in der Tinte enthaltenen thermisch vernetzbaren Komponente.
vi) Polymerisation von zumindest einer in der Tinte enthaltenen polymerisierbaren Komponente.
vii) Chemisorption und/oder Physisorption von zumindest einer in der Tinte enthaltenen Komponente an die zu bedruckende Fläche (3).

Der eigentliche Vorgang des Kapillar-Nanodrucks kann in verschiedenen Ausführungsvarianten erfolgen, die je nach technischer Anwendung vorteilhaft sind. Im Folgenden werden beispielhafte Ausführungsvarianten beschrieben.

Liquid on solid-Kapillar-Nanodruck (LOS-Kapillar-Nanodruck) kann mit beliebigen anderen Ausführungsvarianten des Kapillar-Nanodrucks kombiniert werden. LOS-Kapillar-Nanodruck wird derart durchgeführt, dass zwischen der mit Tinte (4) getränkten monolithischen Kombination aus Substrat (1) und Kontaktelementen (2) sowie der zu bedruckenden Fläche (3) ein Vakuum oder eine Gasphase existiert. Bei besagter Gasphase kann es sich beispielsweise um Luft mit einer spezifisch festgelegten Luftfeuchtigkeit handeln. Je nach technischen Erfordernissen kann besagte Gasphase auch mit bestimmten Gasen oder beliebigen Kombinationen bestimmter Gase angereichert sein, oder die Gasphase kann vollständig aus bestimmten Gasen oder beliebigen Kombinationen bestimmter Gase bestehen. Besagte Gase, die die Gasphase entweder als Reinstoff oder in Form beliebiger Kombinationen bilden können, können unter anderem ausgewählt sein aus Wasser, Sauerstoff, Wasserstoff, Argon, Stickstoff, Helium, Synthesegas, Alkanen, Alkenen, Alkinen, zumindest in Teilbereichen aliphatischen und/oder aromatischen und/oder halogenierten Kohlenwasserstoffen, Ethern, Estern, Silanen, und/oder Siloxanen. Vorteilhafte Ausführungsvarianten des LOS-Kapillar-Nanodrucks können die Verwendung einer inerten Gasphase oder aber die Verwendung einer reaktiven Gasphase vorsehen. Ein kritischer Schritt im Verlauf von LOS-Kapillar-Nanodruck (vergleiche Fig. 1) ist die Bildung der Kapillarbrücken aus Tinte (4) zwischen den Kontaktelementen (2) und der zu bedruckenden Oberfläche (3) während der Annäherung der monolithischen Kombination aus Substrat (1) und Kontaktelementen (2) sowie der zu bedruckenden Oberfläche (3) aneinander. Ein zweiter kritischer Schritt ist das Auseinanderreißen besagter Kapillarbrücken aus Tinte (4) während der Trennung der monolithischen Kombination aus Substrat (1) und Kontaktelementen (2) sowie der zu bedruckenden Fläche (3) voneinander. Dabei bleibt ein Teil der Volumina der Kapillarbrücken der Tinte (4) als Tintentropfen (5) auf der zu bedruckenden Fläche (3) zurück. Die Größe der so auf der zu bedruckenden Fläche (3) abgeschiedenen Tintentropfen (5) lässt sich unter anderem mittels der folgenden Parameter einstellen: Kontaktwinkel zwischen Tinte (4) und Material der Kontaktelemente (2); Kontaktwinkel zwischen Tinte (4) und zu bedruckender Oberfläche (3); Krümmung der Kontaktgeometrie der Kontaktelemente (2); Dauer des Kontaktes zwischen Kontaktelementen (2) und zu bedruckender Oberfläche (3); Geschwindigkeit, mit der nach dem Ende der Kontaktzeit die monolithische Kombination aus Substrat (1) und Kontaktelementen (2) sowie die bedruckte Fläche (3) voneinander getrennt werden.

Liquid in liquid-Kapillar-Nanodruck (LIL-Kapillar-Nanodruck) ist exemplarisch in Fig. 4 dargestellt und entspricht dem oben beschriebenen LOS-Kapillar-Nanodruck, wobei allerdings die zu bedruckende Oberfläche (3) mit einer Matrixflüssigkeit (6) bedeckt ist. LIL-Kapillar-Nanodruck kann mit beliebigen anderen Ausführungsvarianten des Kapillar-Nanodrucks kombiniert werden. Die Matrixflüssigkeit (6) umschließt die nach erfolgtem LIL-Kapillar-Nanodruck auf der bedruckten Fläche (3) abgeschiedenen Tintentropfen (5) außer an der Kontaktfläche zwischen den auf der zu bedruckenden Fläche (3) abgeschiedenen Tintentropfen (5) und der bedruckten Fläche (3). LIL-Kapillar-Nanodruck kann mit einer beliebigen Tinte (4) durchgeführt werden, sofern diese eine höhere Affinität zu den Kontaktelementen (2) und der zu bedruckenden Fläche (3) besitzt als die die zu bedruckende Fläche (3) bedeckende Matrixflüssigkeit (6). Umgekehrt kann jede beliebige Matrixflüssigkeit (6) verwendet werden, solange Matrixflüssigkeit (6) eine geringere Affinität zu den Kontaktelementen (2) und zur zu bedruckenden Oberfläche (3) besitzt als Tinte (4). Vorteil von LIL-Kapillar-Nanodruck ist, dass entweder selektiv die auf der zu bedruckenden Fläche abgeschiedenen Tintentropfen (5) oder selektiv die Matrixflüssigkeit (6) oder sowohl die auf der zu bedruckenden Fläche (3) abgeschiedenen Tintentropfen (5) als auch Matrixflüssigkeit (6) verfestigt werden können. Die Verfestigung der Matrixflüssigkeit (6) kann beispielsweise durch Kristallisation von zumindest einer in ihr enthaltenen kristallisationsfähigen Komponente und/oder durch Verglasung von zumindest einer in ihr enthaltenen glasbildenden Komponente und/oder durch Verdampfung von zumindest einer in ihr enthaltenen flüchtigen Komponente und/oder durch Photovernetzung von zumindest einer in ihr enthaltenen photovernetzbaren Komponente und/oder durch thermische Vernetzung von zumindest einer in ihr enthaltenen thermisch vernetzbaren Komponente und/oder durch Polymerisation von zumindest einer in ihr enthaltenen polymerisierbaren Komponente herbeigeführt werden.

In einer vorteilhaften Ausführungsvariante von LIL-Kapillar-Nanodruck wird die Matrixflüssigkeit (6) so gewählt, dass diese in ihrem flüssigen und/oder in ihrem verfestigten Zustand transparent für elektromagnetische Strahlung in ausgewählten Wellenlängenbereichen ist. In einer anderen vorteilhaften Ausführungsvariante von LIL-Kapillar-Nanodruck wird die Matrixflüssigkeit (6) so gewählt, dass diese in ihrem flüssigen und/oder in ihrem verfestigten Zustand von elektrischen und/oder magnetischen Feldern durchdrungen werden kann. In einer weiteren vorteilhaften Ausführungsvariante von LIL-Kapillar-Nanodruck wird die Matrixflüssigkeit (6) so gewählt, dass diese in ihrem flüssigen und/oder in ihrem verfestigten Zustand durch Einwirkung von elektromagnetischer Strahlung und/oder von elektrischen Feldern und/oder von magnetischen Feldern in zumindest einer ihrer Eigenschaften reversibel oder irreversibel verändert werden kann. Vorgenannte bevorzugte Ausführungsvarianten sind beliebig miteinander kombinierbar.

LIL-Kapillar-Nanodruck besitzt daher unter anderem folgende Vorteile: i) Durch selektive Verfestigung der Matrixflüssigkeit (6) kann ein Monolith aus der verfestigten Matrixflüssigkeit (6) erzeugt werden, dessen Kontaktfläche mit der bedruckten Oberfläche (3) nach Ablösen von der bedruckten Oberfläche (3) und Entfernen der nach wie vor flüssigen, ursprünglich auf der bedruckten Oberfläche (3) abgeschiedenen Tintentropfen (5) Kavitäten an den Positionen der Tintentropfen (5) aufweist, wobei Flächendichten von mehr als 130 Kavitäten pro µm² erreicht werden können. ii) Durch gleichzeitiges oder konsekutives Verfestigen der Matrixflüssigkeit (6) und der gedruckten Tintentropfen (5) kann ein Monolith aus der verfestigten Matrixflüssigkeit (6) erzeugt werden, dessen Kontaktfläche mit der bedruckten Oberfläche (3) nach Ablösen von der bedruckten Oberfläche (3) Arrays von verfestigten Tintentropfen (5) aufweist, wobei Flächendichten von mehr als 130 verfestigten Tintentropfen pro µm² erreicht werden können. iii) Selektives Verfestigen der Matrixflüssigkeit (6) derart, dass diese in ihrer verfestigten Form in adhäsivem Kontakt mit der bedruckten Fläche (3) bleibt, führt zur Einkapselung der gedruckten flüssigen Tintentropfen (5). Somit können beispielsweise über Flächen von mehreren cm² Arrays eingekapselter flüssiger Tintentropfen (5) mit Volumina bis herab zu einigen 10 Zeptolitern mit Flächendichten von mehr als 130 Tintentropfen pro µm² erzeugt werden. iv) Gleichzeitiges oder konsekutives Verfestigen der Matrixflüssigkeit (6) und der gedruckten Tintentropfen (5) derart, dass Matrixflüssigkeit (6) in ihrer verfestigten Form in adhäsivem Kontakt mit der bedruckten Fläche (3) bleibt, führt zur Einkapselung der gedruckten verfestigten Tintentropfen (5). Somit können beispielsweise über Flächen von mehreren cm² Arrays eingekapselter verfestigter Tintentropfen (5) mit Volumina bis herab zu einigen 10 Zeptolitern mit Flächendichten von mehr als 130 Tintentropfen pro µm² erzeugt werden.

Vorstellbar ist, dass LIL-Kapillar-Nanodruck mit gezielt herbeigeführten Diffusionsprozessen kombiniert wird. Beispielsweise ist es denkbar, dass zumindest eine mobile Komponente der Tinte aus flüssigen oder verfestigten Tropfen (5) in die flüssige oder verfestigte Matrixflüssigkeit (6) diffundiert. Umgekehrt ist ebenso vorstellbar, dass zumindest eine mobile Komponente der flüssigen oder verfestigten Matrixflüssigkeit (6) in die flüssigen oder verfestigten Tropfen (5) der Tinte diffundiert. Beide vorgenannten Formen des Stofftransports sind auch kombinierbar. Es können gleichzeitig oder zeitverschoben oder nacheinander jeweils ein oder mehrere Stoffe von der flüssigen oder verfestigten Matrixflüssigkeit (6) in die flüssigen oder verfestigten Tintentropfen (5) und von den flüssigen oder verfestigten Tintentropfen (5) in die flüssige oder verfestigte Matrixflüssigkeit (6) diffundieren. Derartige Transportprozesse können auch für zusätzliche Strukturbildungsprozesse ausgenützt werden. So können beispielsweise durch Ausnutzung des Kirkendall-Effekts entweder die Größen der Tropfen (5) nach dem eigentlichen Kapillar-Nanodruck verändert werden oder in den verfestigten Tintentropfen (5) und/oder in der verfestigten Matrixflüssigkeit (6) gezielt Hohlräume erzeugt werden.

Eine weitere vorteilhafte Ausführungsvariante des Kapillar-Nanodrucks ist elektrochemisch modulierter Kapillar-Nanodruck (EM-Kapillar-Nanodruck), also Kapillar-Nanodruck unter Einwirkung elektrischer Felder. Hierbei können eine oder mehrere Elektroden an der den Kontaktelementen (2) abgewandten Seite des Substrates (1) und/oder in und/oder unterhalb der zu bedruckenden Fläche (3) angebracht sein. Ebenso denkbar ist, dass die monolithische Kombination aus Substrat (1) und Kontaktelementen (2) und/oder die zu bedruckende Fläche (3) selber aus leitfähigem Material bestehen und als Elektroden fungieren. EM-Kapillar-Nanodruck ermöglicht es unter anderem, die Abscheidung von Tintentropfen elektrochemisch zu steuern, wie dies bereits für die Abscheidung von Flüssigkeitstropfen aus einzelnen Cantilever-Spitzen gezeigt wurde.^{xxxii,xxxiii} Weiterhin kann das Verhalten von auf einer Fläche (3) abgeschiedenen Tintentropfen (5), insbesondere der Kontaktwinkel zwischen Tinte und Fläche (3), durch Elektrobenetzungs-Phänomenen oder durch Phänomene in Zusammenhang mit Elektrobenetzung auf Dielektrika gesteuert werden. Diese beiden Phänomene sind für Flüssigkeitstropfen auf leitfähigen oder dielektrischen Oberflächen bereits bekannt.^{xxxiv,xxxv}

Hochtemperatur-Kapillar-Nanodruck (HT-Kapillar-Nanodruck) und Niedrig-Temperatur-Kapillar-Nanodruck (NT-Kapillar-Nanodruck) beinhalten die Durchführung des Kapillar-Nanodruckprozesses entweder ganz oder in Teilbereichen bei Temperaturen oberhalb oder unterhalb der Umgebungstemperatur. Auch HT/NT-Kapillar-Nanodruck kann mit beliebigen anderen Ausführungsvarianten des Kapillar-Nanodrucks kombiniert werden. HT/NT-Kapillar-Nanodruck kann beispielsweise derart durchgeführt werden, dass eine technische Vorrichtung zur Durchführung von Kapillar-Nanodruck ganz oder in Teilbereichen auf eine von der Umgebungstemperatur verschiedene Temperatur gebracht wird. Beispielsweise ist denkbar, dass die monolithische Kombination aus Substrat (1) und Kontaktelementen (2) ganz oder in Teilbereichen auf eine gemäß den technischen Erfordernissen ausgewählte Temperatur gebracht wird. Gleichfalls kann die zu bedruckende Fläche (3) auf eine gemäß den technischen Erfordernissen ausgewählte Temperatur gebracht werden. HT/NT-Kapillar-Nanodruck kann ebenso in Gegenwart beliebiger Temperaturdifferenzen, die zumindest innerhalb von Teilbereichen der technischen Vorrichtung zur Durchführung von Kapillar-Nanodruck erzeugt werden, durchgeführt werden. Besagte Temperaturdifferenzen können etwa innerhalb der monolithischen Kombination aus Substrat (1) und Kontaktelementen (2) oder innerhalb der zu bedruckenden Fläche (3) oder zwischen der monolithischen Kombination aus Substrat (1) und Kontaktelementen (2) und der zu bedruckenden Fläche (3) erzeugt werden. HT/NT-Kapillar-Nanodruck kann in folgenden beispielhaften Ausführungsvarianten durchgeführt werden:
i) Wird die technische Vorrichtung zur Durchführung von Kapillar-Nanodruck ganz oder in Teilbereichen auf Temperaturen unterhalb der Umgebungstemperatur gekühlt, kann Tinte verdruckt werden, die bei Umgebungstemperatur gasförmig wäre oder die zumindest eine Komponente enthält, die bei Umgebungstemperatur gasförmig wäre. Wird diese Variante des NT-Kapillar-Nanodrucks mit LIL-Kapillar-Nanodruck kombiniert, können nach Verfestigung der Matrixflüssigkeit (6) und Erwärmen Felder eingekapselter Tintentropfen (5) erhalten werden, die zumindest eine gasförmige Komponente enthalten. Auf diese Weise lassen sich beispielsweise Felder eingekapselter Volumina erzeugen, in denen jeweils ein über dem Umgebungsdruck liegender Druck herrscht.
ii) Wird die technische Vorrichtung zur Durchführung von Kapillar-Nanodruck ganz oder in Teilbereichen auf Temperaturen oberhalb der Umgebungstemperatur erwärmt, kann Tinte verdruckt werden, die bei Umgebungstemperatur verfestigt wäre oder die zumindest eine Komponente enthält, die bei Umgebungstemperatur verfestigt wäre.
iii) In einer weiteren Ausführungsvariante des HT-Kapillar-Nanodrucks wird die zu bedruckende Fläche (3) auf eine Temperatur erhitzt, die höher als die Temperatur der monolithischen Kombination aus Substrat (1) und Kontaktelementen (2) ist. Enthält die verdruckte Tinte eine Komponente, die bei der Temperatur der monolithischen Kombination aus Substrat (1) und Kontaktelementen (2) flüssig ist oder Bestandteil der Tinte bleibt, die aber bei der Temperatur der zu bedruckenden Fläche (3) verdampft oder sich zersetzt oder eine spezifische chemische Reaktion eingeht, kann dies ausgenutzt werden, um auf der zu bedruckenden Fläche (3) Felder aus Tropften oder Partikeln von Verdampfungs- und/oder Zersetzungs- und/oder Reaktionsprodukten der Tinte zu erzeugen.
iv) In einer weiteren Ausführungsvariante des HT/NT-Kapillar-Nanodrucks wird die zu bedruckende Fläche (3) auf eine Temperatur gebracht, die unter der Temperatur der monolithischen Kombination aus Substrat (1) und Kontaktelementen (2) liegt. Enthält die verdruckte Tinte zumindest eine Komponente, die bei der Temperatur zu bedruckenden Fläche (3) verfestigt ist, kann die auf der zu bedruckenden Fläche (3) abgeschiedene Tinte im Moment der Abscheidung oder zu einem nach dem Zeitpunkt der Abscheidung liegenden Zeitpunkt verfestigt werden.

Mit der Vorrichtung zur Durchführung von Kapillar-Nanodruck lassen sich, wie exemplarisch in Fig. 5 dargestellt, auch Strukturen aus im Verlauf des Kapillar-Nanodruckprozesses verfestigter Tinte drucken, die in eine Richtung senkrecht zur Oberfläche der zu bedruckenden Fläche (3) ausgedehnt sind. Beispielsweise lassen sich mittels Kapillar-Nanodrucks Felder aus senkrecht zur bedruckten Oberfläche (3) orientierten Drähten (7) erzeugen. Die Drähte (7) können unter anderem zumindest eine Komponente enthalten, die ausgewählt ist aus
i) polymeren Materialien oder beliebigen Kombinationen polymerer Materialien, wobei besagte polymere Materialien unter anderem ausgewählt sein können aus
   - organischen Polymeren wie Poly(p-xylylen), Polyacrylamid, Polyimiden, Polyestern, Polyolefinen, Polystyrolen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polyethylenen,
   - fluorhaltigen Polymeren wie Polyvinylidenfluorid, Polytrifluorethylen, Polytretrafluorethylen, Polyhexafluorpropylen,
   - biologischen Polymeren wie Polysacchariden, Cellulose (modifiziert oder nichtmodifiziert), Alginaten, Polypeptiden, Collagen, DNA, RNA,
   - Polymeren, die aus mindestens zwei verschiedenen Wiederholungseinheiten aufgebaut sind, bevorzugt in Form von statistischen Copolymeren, Blockcopolymeren, Propfcopolymeren, Dendrimeren,
   - Copolymeren, die fluorhaltige Comonomere, bevorzugt fluorhaltige Comonomere, die sich aus Fluorethylen, Difluorethylen, Trifluorethylen, Tetrafluorethylen oder Hexafluorpropylen ableiten, enthalten,
   - Dendrimeren,
ii) Leitfähigen und/oder halbleitenden Polymeren,
iii) Salzen,
iv) Metallen wie Gold, Silber, Platin, Palladium, Kupfer, Tantal, Wolfram, Aluminium,
v) anorganischen Oxiden wie Siliziumoxid, Titanoxid, Aluminiumoxid, Tantaloxid,
vi) Amorphen oder in Teilbereichen kristallinen oder vollständig kristallinen Kohlenstoffmaterialien,
vii) Halbleitern, bevorzugt Elementhalbleitern wie beispielsweise Silicium und Germanium oder Verbindungshalbleitern wie beispielsweise Galliumarsenid.

Bevorzugt haben die mittels Kapillar-Nanodruck erzeugten Drähte (7) Durchmesser von weniger als 500 nm, besonders bevorzugt von weniger als 100 nm und am meisten bevorzugt von weniger als 30 nm. Die Länge der Drähte (7) ist bevorzugt größer als 500 nm, besonders bevorzugt größer als 1 µm und am meisten bevorzugt größer als 5 µm. In einer beispielhaften Ausführungsvariante können die Felder von Drähten (7) Flächendichten von mehr als 130 Drähten pro µm² aufweisen und eine Fläche von mehr als 9 cm² einnehmen, wobei die Drähte Durchmesser von 50 nm und Längen von mehr als 2 µm besitzen. Die Erzeugung von Polymer-Drahtfeldern durch Kapillar-Nanodruck erfolgt derart, dass nach Ausbildung der Kapillarbrücken aus Tinte (4) zwischen den Kontaktelementen (2) und der zu bedruckenden Oberfläche (3) die Kontaktelemente (2) und die bedruckte Oberfläche (3) derart voneinander getrennt werden, dass die Kapillarbrücken aus Tinte (4) nicht reißen. Stattdessen wird durch Streckung der Kapillarbrücken aus Tinte (4) und/oder durch Fluss von Tinte aus den Kontaktelementen (2) in die Kapillarbrücken aus Tinte (4) die Länge der Kapillarbrücken aus Tinte (4) dem zunehmenden Abstand zwischen Kontaktelementen (2) und der bedruckten Oberfläche (3) angepasst. Gleichzeitig oder zeitversetzt wird in einer vorteilhaften Verfahrensvariante die Verfestigung der Tinte in den Kapillarbrücken herbeigeführt, wobei die Verfestigungsfront startend von der Grenzfläche zwischen bedruckter Fläche (3) und den Kapillarbrücken aus Tinte (4) von der bedruckten Fläche (3) entlang der Kapillarbrücken aus Tinte (4) propagiert. Folglich nimmt die Länge der verfestigten Segmente (8) der Kapillarbrücken aus Tinte zu, während sich zwischen den Verfestigungsfronten und den Kontaktelementen (2) nach wie vor flüssige Tinte (9) befindet. Die Verfestigung der Tinte in den Kapillarbrücken (4) zwischen bedruckter Fläche (3) und Verfestigungsfront kann beispielsweise durch Abkühlen der Tinte in den Kapillarbrücken (4) in Gegenwart einer Temperaturdifferenz zwischen Kontaktelementen (2) und bedruckter Fläche (3) erfolgen. Ebenso ist eine Verfestigung der Kapillarbrücken aus Tinte (4) zwischen bedruckter Fläche (3) und Verfestigungsfront durch elektrochemische Reaktionen in der Kapillarbrücke, etwa Polymerisation oder elektrochemischer Abscheidung von Metallen, möglich. Die Trennung der Kontaktelemente (2) von den so erhaltenen, senkrecht auf der bedruckten Fläche (3) stehenden Drähten (7) kann unter anderem erfolgen, indem die Zuführung von Tinte zu den Kontaktelementen (2) temporär oder dauerhaft unterbunden wird, oder indem Kontaktelemente (2) und bedruckte Fläche (3) mit größerer Geschwindigkeit voneinander getrennt werden.

Eine weitere vorteilhafte Verfahrensvariante zur Verfestigung der Drähte (7) beruht darauf, dass die Kapillarbrücken aus Tinte (4) zumindest eine photovernetzbare Komponente und/oder zumindest eine thermisch vernetzbare Kompontente und/oder zumindest eine polymerisierbare Komponente enthalten, so dass die Kapillarbrücken aus Tinte (4) als Ganzes durch Photovernetzung und/oder thermische Vernetzung und/oder Polymerisation verfestigt werden können.

Mit Kapillarnanodruck erzeugte Felder von Drähten können Drähte enthalten, die senkkrecht auf Fläche (3) stehen. In einer vorteilhaften Ausführungsvariante kann Kapillar-Nanodruck benutzt werden, um Felder aus Drähten (7), deren Längsachse mit der bedruckten Fläche (3) einen Winkel kleiner 90°, bevorzugt kleiner 70°, einschließt, zu erzeugen. Hierzu wird während des Trennens der Kontaktelemente (2) von der bedruckten Fläche (3) die Trennungsbewegung in senkrechter Richtung mit einem Querversatz zwischen der monolithischen Kombination aus Substrat (1) und Kontaktelementen (2) sowie der bedruckten Fläche (3) gegeneinander, also einer Scherbewegung zwischen der monolithischen Kombination aus Substrat (1) und Kontaktelementen (2) sowie der bedruckten Fläche (3), kombiniert.

Beispiel für ein Funktionsmaterial, dass mittels Kapillar-Nanodruck zu Nanodrähten geformt werden kann, ist das ferroelektrische Polymer Poly(vinylidenfluorid-*stat*-trifluorethylen) P(VDF-*ran*-TrFE), welches als Schmelze aus über den Schmelzpunkt von P(VDF-*ran*-TrFE) erhitzten Kontaktelementen (2) auf eine zu bedruckende Fläche (3) abgeschieden wird. Ebenso können zur Herstellung von Drahtarrays mittels EM-Kapillar-Nanodruck elektrochemische Methoden adaptiert werden, die bis dato in serieller Weise zwischen einzelnen Cantilever-Spitzen oder Mikropipetten und darunter befindlichen Flächen demonstriert wurden. Beispiele hierfür sind die Herstellung von Metallnanodrähten^{xvii} sowie Elektropolymerisation leitfähiger Polymere.^{xxxvi-xxxviii} Als zu bedruckende Flächen (3) eignen sich für Kombinationen aus HT-Kapillar-Nanodruck und EM-Kapillar-Nanodruck insbesondere ITO-Glass, Metalloberflächen oder Kohlenstoffmaterialien.

Die technische Vorrichtung zur Durchführung von Kapillar-Nanodruck sowie die erfindungsgemäße Methode des Kapillar-Nanodrucks lösen eine Reihe von Problemen, die nach dem Stand der Technik nicht gelöst werden können:
Durch Bereitstellen des erfindungsgemäßen Verfahrens ist es den Erfindern gelungen, ein Verfahren bereitzustellen, in denen Felder von Tintentropfen bereitgestellt werden können, die die Nachteile des Stands der Technik in überraschender Weise überwinden.

Im Detail kann die Art der Abscheidung von Tinte durch Kapillar-Nanodruck durch eine Vielzahl von Prozessparametern flexibel gesteuert werden, etwa das gezielte Design der Kapillarbrücken aus Tinte (4) zwischen Kontaktelementen (2) und zu bedruckender Fläche (3) und die gezielte Kontrolle des Brechens besagter Kapillarbrücken, so dass Größen, Morphologien, und chemische Beschaffenheit der abgeschiedenen Tintentropfen flexibel einstellbar sind. Kapillar-Nanodruck erlaubt weiterhin flexible Kombination mit elektrischen Feldern, elektrochemischer Modulierung und/oder Temperaturdifferenzen, um die Abscheidung der Tinte zu steuern, sowie Zuführung zusätzlicher Tinte in die Kontaktzone zwischen Kontaktelementen (2) und zu bedruckender Fläche (3), etwa um Drähte (7) zu erzeugen. Stempelbasierte kontaktlithographische Methoden weisen diese Vorteile aufgrund ihrer intrinsischen Limitierung auf den Transfer dünner, an der Stempeloberfläche adsorbierter Schichten nicht auf. Insbesondere ist es mit Hilfe stempelbasierter kontaktlithographischer Methoden nicht möglich, auf der bedruckten Fläche andere Strukturen als zweidimensionale dünne Schichten zu erzeugen. Diese Limitierung wird durch Kapillar-Nanodruck in vorteilhafter Weise überwunden.

Generell ist die Erzeugung großflächiger nanoskaliger Punkt- oder Tropfenmuster, die bevorzugt nächste-Nachbar-Abstände von weniger als einem Mikrometer bei einer Gesamtfläche von vorzugsweise mehr als einem Quadratmillimeter aufweisen, nach dem Stand der Technik nicht gelöst. Typischerweise beläuft sich die Anzahl der verdruckten Punkte pro mm² gemäß dem Stand der Technik auf einige 100. Eine marginale Erhöhung dieser Zahl um maximal eine Größenordnung kann erreicht werden, wenn der Stempel mittels komplexer technischer Vorrichtungen zwischen aufeinander folgenden Kontakten mit der zu verdruckenden Fläche jeweils einem Querversatz unterworfen wird, der Druckprozess also teilweise seriell durchgeführt wird.^{xii} Dies bedingt die unvorteilhafte Notwendigkeit, die relative Positionierung des Stempels zwischen zwei Kontakten in technisch aufwendiger Weise mittels einer ansonsten für Rastersondenmikroskopie benutzten Mechanik präzise einzustellen. Es ist weiterhin unvorteilhaft, dass zumindest zur Sicherstellung gleichbleibender Druckqualität zwischen den Kontakten jeweils neue Tinte aufgenommen werden muss und dadurch für technische Anwendungen unvorteilhafte Zykluszeiten pro Kontakt von mehreren Minuten erforderlich sind. Im Gegensatz dazu können in einer repräsentativen Ausführungsvariante des Kapillar-Nanodrucks 5333333 Punkte pro mm² in Form dichter hexagonaler Felder auf einer zu bedruckenden Fläche von mehreren Quadratzentimetern parallel durch einen einzigen Kontakt erzeugt werden.

Im Folgenden werden exemplarische Anwendungen für Kapillar-Nanodruck beschrieben:
Eine exemplarische Anwendung von Kapillar-Nanodruck ist die Beschichtung von Oberflächen mit Feldern von mikro- bis mesoporösen Nanopartikeln mit Volumina, die bevorzugt kleiner als ein Pikoliter, besonders bevorzugt kleiner als ein Femtoliter, am meisten bevorzugt kleiner als ein Attoliter sind und die kontinuierliche oder diskrete Porenstrukuren mit Porendurchmessern kleiner 50 nm, bevorzugt kleiner 20 nm, besonders bevorzugt kleiner 2 nm, aufweisen. Kapillar-Nanodruck löst das Problem, dass die Abscheidung mikro- bis mesoporöser Nanopartikel auf Oberflächen aus Lösung^{xxxix,xl} erfordert, besagte mikro- bis mesoporöse Nanopartikel über komplexe chemische Reaktionen an besagte Oberfläche zu fixieren, während kontrollierte räumliche Positionierung besagter mikro- bis mesoporöser Nanopartikel nicht erreicht werden kann. Mittels Kapillar-Nanodruck können Felder von Nanopartikeln aus Zeolit, MCM^{xli} und SBA^{xlii} sowie allgemein mikro- bis mesoporöse Nanopartikel aus anorganischen Oxiden wie Siliziumoxid, Titanoxid, Aluminiumoxid oder Tantaloxid, aus Metallen und aus Kohlenstoffmaterialien oder aus MOFs ("metal-organic frameworks") auf zu bedruckenden Oberflächen (3) hergestellt werden. Besagte Nanopartikel können dabei beispielsweise innere Porenstrukturen^{xliii-xlv} aufweisen, die parallel angeordnete zylindrische Poren oder dreidimensional kontinuierlichen Porensysteme, wie etwa kubische Porensysteme, enthalten. In einer bevorzugten Ausführungsvariante des Kapillar-Nanodrucks werden zur Herstellung der gewünschten mikro- bis mesoporösen Nanopartikel geeignete Sol-Gel-Lösungen verdruckt. In einer besonders bevorzugten Ausführungsvariante wird EM-Kapillar-Nanodruck verwendet, um unter dem Einfluss von elektrischen Feldern während des Kapillar-Nanodrucks die Orientierung der Mikro/Mesoporen relativ zur bedruckten Oberfläche (3) zu kontrollieren.

Eine weitere exemplarische Anwendung von Kapillar-Nanodruck ist Nanotropfen-Lithographie, welche die Verwendung von mittels Kapillar-Nanodruck erzeugten Feldern von Tintentropfen (5) für die weitere lithographische und/oder topographische Strukturierung der bedruckten Oberfläche (3) verwendet. Vorteil der Kombination aus Kapillar-Nanodruck und Nanotropfen-Lithographie ist, dass nach dem Stand der Technik notwendige Verfahrensschritte zur lithographischen und/oder topographischen Strukturierung von Oberflächen (3) entfallen. So können beispielsweise lithographische Methoden wie Blockcopolymer-Lithographie ersetzt werden, in deren Verlauf Masken oder Template erst aufwendig erzeugt und dann zerstört werden. Ebenso können lithographische Methoden ersetzt werden, die komplexe Maskentransferprozesse oder komplexe Musterübertragungsprozesse beinhalten. Die Herstellung einer freistehenden ultradünnen Membran mit dichten Feldern von durchgehenden Poren mit Porendurchmessern kleiner 100 nm ist exemplarisch in Fig. 6a-c dargestellt. Mittels LOS-Kapillar-Nanodruck werden zunächst Felder von Tropfen (5) eines photopolymerisierbaren Polymers mit Volumina von einigen 10 Zeptolitern auf Flächen (3) abgeschieden, wobei vorteilhafte Ausführungsvarianten die Verwendung von Flächen (3) beinhalten, die oxidisch sind oder mit Gold beschichtet wurden. Optional können die Tintentropfen (5) verfestigt werden. In einem weiteren Schritt wird eine weitere Schicht (10) auf die Fläche (3) und die Tropfen (5) abgeschieden. Beispielhaft kann dies geschehen, indem eine SAM ("self-assembled monolayer") als weitere Schicht (10) erzeugt wird. Besonders vorteilhaft sind vernetzbare SAMs, beispielsweise Diacetylen-SAMs^{xlvi,xlvii} und/oder Phenyl-SAMs und/oder Diphenyl-SAMs,^{xlviii} die nach Abscheidung auf Fläche (3) vernetzt werden. Optional kann sich Hochtemperaturbehandlung anschließen, um den Graphitanteil der vernetzten SAMs zu erhöhen. Die Tropfen (5) werden mit einer geeigneten Methode gelöst. Beispielsweise kann dies mechanisch, mit Ultraschall, durch Exposition zu Flüssigkeitsströmen, durch Auflösen in Lösungsmitteln, durch chemische Zersetzung oder durch thermische Zersetzung geschehen. Die vernetzten SAM-Membranen werden anschließend von der Fläche (3) entfernt. Dies kann unter anderem durch schnelle Temperaturänderung, Ätzen der Fläche (3) ganz oder in Teilbereichen, Aufschwämmen mit Lösungsmitteln, Ultraschallbehandlung, chemisches Lösen der Bindungen zwischen Schicht (10) und Fläche (3) (etwa mit Ioddampf zum Brechen von Gold-Schwefel-Bindungen bei Thiol-auf-Gold-SAMs^{xlix}) oder durch mechanisches Abheben geschehen. In einer vorteilhaften Ausführungsvariante werden leicht auflösbare Flächen (3) aus wiedergewinnbaren Materialien wie etwa kristallinem Kaliumchlorid verwendet. Schicht (10) wird somit als freistehende Membran mit einer Dicke bevorzugt von weniger als 50 nm, besonders bevorzugt von weniger als 10 nm und am meisten bevorzugt von weniger als 5 nm erhalten, die dichte Felder von Poren mit Durchmessern bevorzugt von weniger als 500 nm, besonders bevorzugt von weniger als 100 nm und am meisten bevorzugt von weniger als 50 nm sowie nächster Nachbar-Abstände zwischen den Poren bevorzugt von weniger als 500 nm und besonders bevorzugt von weniger als 100 nm aufweist. Besagte Membranen können Flächen von beispielsweise mehr als 9 cm² aufweisen. Die so erhaltenen Membranen können in elektrisch leitfähiger Form oder in halbleitender Form hergestellt werden, so dass diese über elektrochemische Potentiale steuerbare Einzelkomponenten-Permselektivität und/oder elektrochemisch modulierbare Ionentransportselektivität aufweisen.

Weiterhin erfordern viele lithographische und/oder topographische Strukturierungsprozesse nach dem Stand der Technik aufwendige Selbstorganisationsschritte zur Erzeugung selbstorganisierter Strukturen, deren Muster in ein weiteres Material übertragen werden, wobei besagte selbstorganisierte Strukturen während der Musterübertragung zerstört werden. Beispiele für derartige lithographische und/oder topographische Strukturierungsprozesse sind Blockcopolymer-Lithographie oder die Herstellung von selbstgeordnetem porösem Aluminiumoxid durch zweistufige Anodisation, wobei in einem ersten, mehrere Stunden bis mehrere Tage dauernden Anodisationsschritt die Selbstorganisation der Felder der wachsenden Poren stattfindet. Die im ersten Anodisationsschritt gebildete poröse Aluminiumoxidschicht wird anschließend weggeätzt, und die Abdrücke der Poren der weggeätzten Aluminiumoxidschicht im verbleibenden Aluminiumsubstrat dienen in einem zweiten Anodisationsschritt als Keime für das Wachstum von Poren in selbstgeordneten hexagonalen Arrays.^{xix,xx} Kapillar-Nanodruck kombiniert mit Nanotropfenlithographie ersetzt einerseits zeitaufwendige Selbstorganisationsschritte zur Erzeugung der zu übertragenden Muster, da das Muster durch die Anordnung der Kontaktelemente (2) vorgegeben wird. Weiterhin umgeht Kapillar-Nanodruck kombiniert mit Nanotropfenlithographie die Zerstörung der durch aufwendige Selbstorganisationsschritte erzeugten selbstorganisierten Strukturen bei der Musterübertragung.

Die Herstellung von geordneten porösen Materialien durch Kapillar-Nanodruck kombiniert mit Nanotropfenlithographie ist beispielhaft in Fig.6 a,d,e gezeigt. Via Kapillar-Nanodruck werden Felder von Tintentropfen (5) auf ein Material (12) aufgebracht. Die Tinte ist so beschaffen, dass diese an den Stellen, an denen Tintentropfen abgeschieden werden, Vertiefungen (11) in Material (12) ätzt. Diese Vertiefungen können als Keime für Porenwachstum in einem weiteren Porenwachstumsschritt dienen, so dass Poren (13) an den durch Kapillar-Nanodruck definierten Positionen erzeugt werden. Handelt es sich bei Material (12) beispielsweise um Aluminium, kann so poröses Aluminiumoxid mit durch Kapillar-Nanodruck definierten Porenanordnungen erzeugt werden. Auf diese Weise lässt sich der zeitaufwendige erste Anodisationsschritt in der Herstellung von selbstgeordnetem porösem Aluminiumoxid vermeiden.

Wird beispielsweise ein Aluminiumstück (12) mit Feldern von Kontaktelementen (2), die über eine Fläche von 9 cm² in einem hexagonalem Array mit einem nächster-Nachbar-Abstand von 65 nm angeordnet sind, in Kontakt gebracht, und werden dabei auf dem Aluminiumstück (12) Tropfen einer Tinte abgeschieden, die die Eigenschaft hat, Aluminium aufzulösen, können in dem Aluminiumstück (12) Felder von Vertiefungen (11) gebildet werden, die über eine Fläche von 9 cm² in einem hexagonalem Array mit einem nächster-Nachbar-Abstand von 65 nm angeordnet sind. In einem anschließenden Anodisationsschritt können durch Anodisation mit Oxalsäure-haltigem Elektrolyt bei 40 V Felder von Poren (13) in einer durch die Anodisation gebildeten Aluminiumoxidschicht über eine Fläche von 9 cm² erzeugt werden, wobei die Poren in diesem Beispiel in einem hexagonalem Array mit einem nächster-Nachbar-Abstand von etwa 65 nm angeordnet sind. Besagte Poren (13) bilden sich an den Positionen der Vertiefungen (11), die als Keime für das Porenwachstum wirken. Die Poren (13) besitzen im hier geschilderten Beispiel einen Durchmesser von bevorzugt 35 nm sowie eine Länge bevorzugt von mehr als 1 µm, besonders bevorzugt von mehr als 10 µm und am meisten bevorzugt von mehr als 100 µm. Vorteilhaft ist die Anordnung der Vertiefungen (11) in Aluminiumstück (12) derart, dass die Vertiefungen (11) ein hexagonales Array mit einem nächster-Nachbar-Abstand bilden, der einem nächster-Nachbar-Abstand entspricht, der sich in zumindest einem selbstgeordneten Anodisationsregime zur Erzeugung von selbstgeordnetem porösen Aluminiumoxid zwischen den Poren einstellt. Ist die Anordnung der Kontaktelemente (2) der monolithischen Kombinationen aus Substrat (1) und Kontaktelementen (2) so ausgeführt, dass diese einen einkristallinen Ordnungsgrad aufweist, können die Porenanordnungen in über Kapillar-Nanodruck erhaltenem porösen Aluminiumoxid einen höheren Ordnungsgrad aufweisen als in selbstgeordnetem porösen Aluminiumoxid.

Wie in Fig. 7 beispielhaft dargestellt ist, kann Kapillar-Nanodruck mit metall-assistiertem Ätzen von Silizium^{l-liv} kombiniert werden, um entweder poröses Silizium oder Felder von Silizium-Nanodrähten herzustellen. In einer vorteilhaften Ausführungsvariante wird dabei die gesamte Fläche eines Siliziumwafers (14) mit Kapillar-Nanodruck in einem Schritt bedruckt. Die Kombination aus Kapillar-Nanodruck mit metall-assistiertem Ätzen löst dabei das Problem, dass nach dem Stand der Technik bei der Herstellung entweder von porösem Silizium oder von Feldern von Silizium-Nanodrähten Masken erzeugt werden müssen, die im Verlauf von nach dem Stand der Technik durchgeführtem metall-assistiertem Ätzen von Silizium wiederum zerstört werden. Beispiele für derartige Opfer-Masken, deren Herstellung und/oder Transfer mit erheblichem Aufwand verbunden ist, sind kolloidale Monolagen,^{li} Blockcopolymer-Masken^{liii} und ultradünne nanoporöse Aluminiumoxid-Schichten.^{liv} Poröses Silizium kann beispielsweise erfindungsgemäß hergestellt werden, indem per Kapillar-Nanodruck Felder von Tintentropfen (5) auf einen Siliziumwafer (14) aufgebracht werden, wobei die Tinte zumindest eine Vorläuferverbindung für ein Metall aufweist, welches sich für metall-assistiertes Ätzen eignet. Besagte Vorläuferverbindung für ein Metall, welches sich für metall-assistiertes Ätzen eignet, wird anschließend in besagtes Metall umgewandelt. Als Ergebnis werden Felder von Metall-Nanopartikeln (15) auf Siliziumwafer (14) erhalten, wobei die Position der Metall-Nanopartikel (15) durch die Anordnung der Kontaktelemente (2) in den monolithischen Kombinationen aus Substrat (1) und Kontaktelementen (2) vorgegeben ist (Fig. 7a). Die Felder der Metall-Nanopartikel (15) bestehen vorzugsweise aus Nanopartikeln aus einem Metall, dass ausgewählt ist aus Gold, Silber, Platin und Palladium. Weiterhin weisen die Felder aus Metall-Nanopartikeln (15) vorzugsweise einen nächster-Nachbar-Abstand von weniger als 100 nm und besonders bevorzugt von weniger als 60 nm auf. Die Metall-Nanopartikel (15) besitzen bevorzugt einen Durchmesser von weniger als 100 nm, besonders bevorzugt von weniger als 60 nm und am meisten bevorzugt von weniger als 30 nm. Durch metall-assistiertes Ätzen werden an den Positionen der Metall-Nanopartikel (15) Poren in Siliziumwafer (14) erzeugt (Fig. 7b).

Die Erzeugung von Silizium-Nanodrähten kann unter anderem wie folgt erfolgen: Durch Kapillar-Nanodruck werden zunächst Felder von Tropfen einer Tinte (5) auf einen Siliziumwafer (14) aufgebracht, wobei besagte Tintentropfen optional verfestigt werden können (Fig. 7c). Anschließend wird Siliziumwafer (14) mit geeigneten Methoden mit einem für metall-assistiertes Ätzen geeigneten Metall (16) beschichtet (Fig. 7d). Vorzugsweise ist dieses Metall ausgewählt aus Gold, Silber oder Platin. Anschließendes metall-assistiertes Ätzen führt zu Auflösung des Siliziums dort, wo das Silizium in direktem Kontakt mit Metall (16) ist, während an den Positionen der Tintentropfen (5) kein direkter Kontakt zwischen Siliziumwafer (14) und Metall (16) besteht. An den Positionen der Tintentropfen (5) bleiben somit Silizium-Nanodrähte mit einem Durchmesser von bevorzugt weniger als 100 nm, besonders bevorzugt von weniger als 50 nm und am meisten bevorzugt von weniger als 20 nm sowie mit Längen von bevorzugt mehr als 100 nm, besonders bevorzugt mehr als 1000 nm und am meisten bevorzugt von mehr als 2 µm stehen (Fig. 7e). In einer beispielhaften Verfahrensvariante weist die verwendete Kombination aus Substrat (1) und Kontaktelementen (2) hexagonale Felder von Kontaktelementen (2) mit einem nächster-Nachbar-Abstand von 100 nm und einer Flächendichte von 130 Kontaktelementen (2) pro Quadratmikrometer auf. Durch Kapillar-Nanodruck auf einen zuvor von nativem Oxid befreiten Siliziumwafer (14) werden in diesem Beispiel Felder von mittels geeigneter Methoden verfestigter Tintentropfen (5) mit einem nächster-Nachbar-Abstand von 100 nm und einer Flächendichte von 130 Tintentropfen (5) pro Quadratmikrometer erhalten. Im nächsten Schritt wird durch eine geeignete Methode ein Film aus einem für metall-assistiertes Ätzen geeigneten Metall (16) auf Siliziumwafer (14) aufgebracht. Die durch anschließendes metall-assistiertes Ätzen erhaltenen Silizium-Nanodrähte bilden im beschriebenen Beispiel hexagonale Felder mit einem nächster-Nachbar-Abstand von 100 nm und einer Flächendichte von 130 Silizium-Nanodrähten pro Quadratmikrometer.

Das Prinzip pseudoergodischer Labor-in-Nanotropfen-Konfigurationen ist exemplarisch in Fig. 8a dargestellt. Die Herstellung pseudoergodischer Labor-in-Nanotropfen-Konfigurationen werden zunächst Tintentropfen mittels Kapillar-Nanodruck auf eine Fläche (3) gedruckt. Fläche (3) ist vorzugsweise ausgeführt aus einem Material, das für ausgewählte Wellenlängenbereiche elektromagnetischer Strahlung transparent ist. In einer bevorzugten Ausführungsvariante erfolgt das Abscheiden der Felder der Tintentropfen mittels LIL-Kapillar-Nanodruck. Bevorzugt ist die Fläche (3) bedeckende Matrixflüssigkeit (6) im flüssigen und/oder verfestigten Zustand für ausgewählte Wellenlängenbereiche elektromagnetischer Strahlung transparent. Matrixflüssigkeit (6) kann entweder im flüssigen Zustand gehalten oder verfestigt werden. Als Resultat können beispielsweise dichte Felder eingekapselter Tintentropfen (5) erhalten werden.

Bevorzugt sind die dichten Felder eingekapselter Flüssigkeitstropfen (5) so ausgeführt, dass einzelne Flüssigkeitstropfen mit optischer Mikroskopie aufgelöst werden können. In einer vorteilhaften Ausführungsvariante für pseudoergodische Labor-in-Nanotropfen-Konfigurationen wird daher ein nächster-Nachbar-Abstand zwischen den eingekapselten Tintentropfen (5) gewählt, der zwischen 400 nm und 700 nm liegt. Vorteilhafte Methoden zur mikroskopischen Beobachtung einzelner Tintentropfen sind beispielsweise konfokale Laser-Scanning-Mikroskopie, Fluoreszenz-Mikroskopie oder Interne Totalreflexionsfluoreszenzmikroskopie (TIRF). Vorteil dieser Methoden ist unter anderem, dass bei Auflösung einzelner Tintentropfen eine große Anzahl verschiedener Tintentropfen entweder sukzessive oder parallel beobachtet werden kann. Auch Methoden wie beispielsweise Einzelmolekülspektroskopie und Fluoreszenzkorrelations-Spektroskopie können zur Untersuchung einzelner Flüssigkeitstropfen angewendet werden. Auf diese Weise können etwa in einzelnen Tintentropfen enthaltene Analyt-Moleküle über einen längeren Zeitraum beobachtet werden, wobei derartige Beobachtungen an vielen Tintentropfen wiederholt werden können oder parallel durchgeführt werden können. In Fig. 8a ist beispielhaft dargestellt, wie ein einzelner eingekapselter Tintentropfen im Fokusvolumen (17) eines konfokalen Laser-Scanning-Mikroskopes positioniert ist, wobei entweder besagter Tintentropfen über längere Zeit beobachtet werden kann oder im Scanning-Modus eine große Zahl von Tintentropfen sukzessive beobachtet werden kann.

Die eingekapselten Tintentropfen (5) können als parallele Felder von Nanoreaktoren für Nanochemie-Ensemble-Untersuchungen oder als parallele Felder von Nanocontainern für parallele Ensemble-Untersuchungen beispielsweise der Dynamik oder der Fluoreszenz von Analyt-Molekülen verwendet werden. Beispielsweise können Tinten verdruckt werden, die eine Art oder mehrere Arten von Analyt-Molekülen enthalten, wobei die Konzentration der Analyt-Moleküle in vorteilhafter Weise so gewählt werden kann, dass im Durchschnitt ein Analyt-Molekül in einem Tintentropfen enthalten ist. Diese Ausführungsvariante erlaubt in vorteilhafter, über den Stand der Technik hinausgehender Weise die massiv-parallele Beobachtung von Ensembles von Molekülen mit Einzelmolekülauflösung. Denkbar ist, dass den einzelnen Tintentropfen der Felder aus Tintentropfen (5) durch Transportprozesse zumindest eine Substanz durch die flüssige oder verfestigte Matrixflüssigkeit zugeführt wird und durch besagte Zuführung von zumindest einer Substanz in den Tintentropfen stattfindende Veränderungen mit geeigneten Methoden beobachtet werden. Denkbar ist ebenfalls, dass zumindest eine in den Tintentropfen enthaltene Substanz durch einen Transportprozess ganz oder teilweise in die flüssige oder verfestigte Matrixflüssigkeit (6) überführt wird und die durch besagte Überführung in den Tintentropfen eintretenden Veränderungen mit geeigneten Methoden untersucht werden. Bevorzugt ist die in Kontakt mit den Tintentropfen (5) befindliche bedruckte Fläche (3) katalytisch aktiv. Beispielsweise ist denkbar, dass Fläche (3) aus Titanoxid oder aus einem mit Titanoxid beschichteten Material besteht und photokatalytische Aktivität aufweist. Auf diese Weise kann etwa verfolgt werden, wie in vielen parallel angeordneten Tintentropfen ausgewählte Farbstoffmoleküle gebleicht werden. Es ist denkbar, mittels pseudoergodischer Labor-in-Nanotropfen-Konfigurationen die katalytische Aktivität von Oberflächen mit hohem Durchsatz zu charakterisieren. Vorstellbar ist ebenso, die Zeitabhängigkeit der Fluoreszenz von Farbstoffmolekülen, die dreidimensionale Orientierung und/oder Rotationsdiffusion von Übergangsdipolmomenten von Farbstoffmolekülen, die molekulare Dynamik von ausgewählten Molekülen sowie reversible oder irreversible Isomerisierungen wie beispielsweise Photoisomerisierungen in pseudoergodischen Labor-in-Nanotropfen-Konfigurationen zu beobachten. Bevorzugt werden derartige Beobachtungen derart ausgeführt, dass diese einerseits an einzelnen, in jeweils einem Tintentropfen enthalten Analyt-Molekülen erfolgen, dass aber andererseits derartige Beobachtungen an vielen verschiedenen Tintentropfen parallel oder nacheinander durchgeführt werden.

Pseudoergodische *lab-on-chip*-Konfigurationen, die vorzugsweise massiv parallele Einzelmoleküldetektion von Analyt-Molekülen erlauben, lassen sich über die Abscheidung von Feldern von Tintentropfen (5) auf Flächen (3) herstellen, wobei die Tintentropfen beispielsweise durch Verdunsten einer flüchtigen Komponente verfestigen und die verfestigten Tintentropfen vorzugsweise punktförmige Beschichtungen (18) auf der Fläche (3) bilden. Das Prinzip pseudoergodischer *lab-on-chip*-Konfigurationen ist in Fig. 8b dargestellt. Eine vorteilhafte Variante der Bildung besagter punktförmiger Beschichtungen (18) beinhaltet die Verbindung des Materials, aus dem besagte punktförmige Beschichtungen (18) bestehen, mit der Fläche (3) über kovalente Bindungen und/oder über Wasserstoffbrückenbindungen und/oder über elektrostatische Wechselwirkungen, die in Form von van der Waals-Wechselwirkungen und/oder in Form von Wechselwirkungen zwischen geladenen Teilchen und/oder geladenen Oberflächen vorliegen können. In einer möglichen Ausführungsvariante besteht die Oberfläche der Fläche (3) aus Gold oder aus Hydroxyl-Gruppen. Das Material, aus dem die punktförmigen Beschichtungen (18) bestehen, kann unter anderem über Thiol-Gruppen und/oder über Silan-Gruppen und/oder über Halogensilan-Gruppen und/oder über Alkoxysilan-Gruppen und/oder über Phosphonat-Gruppen und/oder 1-Alkenyl-Gruppen an Fläche (3) binden. Weiterhin kann das Material, aus dem die punktförmigen Beschichtungen (18) bestehen, zumindest eine weitere funktionelle Gruppe aufweisen, die keine Bindungen zu Fläche (3) bildet, oder Kombinationen aus zumindest zwei weiteren funktionellen Gruppen aufweisen, die jeweils keine Bindungen mit Fläche (3) bilden. Besagte funktionelle Gruppen, die keine Bindungen mit Fläche (3) bilden, können beispielsweise ausgewählt sein aus Alkyl-Gruppen, Derivaten von Alkyl-Gruppen, AlkenylGruppen, Alkinyl-Gruppen, Phenyl-Gruppen, Derivaten von Phenyl-Gruppen, Halogenalkyl-Gruppen, Halogenaryl-Gruppen, Hydroxyl-Gruppen, Carbonyl-Gruppen, Aldehyd-Gruppen, Carboxyl-Gruppen, Keto-Gruppen, Carbonat-Gruppen, Ether-Gruppen, Ester-Gruppen, Alkoxy-Gruppen, Peroxo-Gruppen, Acetal-Gruppen, Halbacetal-Gruppen, Amino-Gruppen, Amido-Gruppen, Imino-Gruppen, Imido-Gruppen, Azido-Gruppen, Azo-Gruppen, CyanatGruppen, Nitrat-Gruppen, Nitrilo-Gruppen, Nitrito-Gruppen, Nitro-Gruppen, Nitroso-Gruppen, Pyridino-Gruppen, Thiol-Gruppen, Sulfid-Gruppen, Disulfid-Gruppen, Sulfoxid-Gruppen, Sulfonyl-Gruppen, Sulfino-Gruppen, Sulfo-Gruppen, Thiocynanat-Gruppen, SulfatGruppen, Sulfonat-Gruppen, Phosphin-Gruppen, Phosphonat-Gruppen und/oder PhosphatGruppen.

Das Material, aus dem die punktförmigen Beschichtungen (18) bestehen, kann beispielsweise SAMs ("self-assembled monolayers") bilden. Die punktförmigen Beschichtungen (18) weisen bevorzugt Durchmesser von weniger als 100 nm, besonders bevorzugt von weniger als 50 nm und am meisten bevorzugt von weniger als 20 nm auf. In einer vorteilhaften Ausführungsvariante pseudoergodischer *lab-on-chip-*Konfigurationen wird der nächste-Nachbar-Abstand zwischen den punktförmigen Beschichtungen (18) so gewählt, dass dieser mindestens 400 nm und maximal 700 nm beträgt, so dass jeweils eine einzelne punktförmige Beschichtung (18) mittels optischer Mikroskopie aufgelöst werden kann. Vorteilhafte Methoden zur mikroskopischen Untersuchung von Ensembles punktförmiger Beschichtungen (18) mit Auflösung einzelner punktförmiger Beschichtungen sind beispielsweise konfokale Laser-Scanning-Mikroskopie, Fluoreszenz-Mikroskopie oder Interne Totalreflexionsfluoreszenzmikroskopie. Folglich können beispielsweise eine große Zahl einzelner Immobilisierungsereignisse mit Einzelmolekül-Auflösung sukzessive und/oder parallel beobachtet werden. Denkbar ist weiterhin, zur Beobachtung von Bindungs- oder Immobilisierungsereignissen auf den punktförmigen Beschichtungen (18) rastersondenmikroskopische Methoden einzusetzen.

Mittels geeigneter Methoden kann beispielsweise pro punktförmiger Beschichtung (18) jeweils ein Analyt-Molekül immobilisiert werden. Jedoch ist ebenso denkbar, dass pro punktförmiger Beschichtung (18) mehrere Analyt-Moleküle immobilisiert werden. Die Immobilisierung von Analyt-Molekülen kann beispielsweise über nicht-spezifische Adsorption erfolgen. Vorkonzentrations-Sensorik kann etwa auf Basis von nichtspezifischer Adsorption von Analyt-Molekülen betrieben werden, wobei die Zahl der pro punktförmiger Beschichtung (18) immobilisierten Moleküle beispielsweise über Fluoreszenzintensitäten bestimmt werden kann. Ebenso ist denkbar, dass die punktförmigen Beschichtungen (18) chemisch oder biochemisch derart modifiziert werden, dass ausgewählte Analyt-Moleküle spezifisch an die punktförmigen Beschichtungen (18) binden. Die Modifizierung der punktförmigen Beschichtungen (18) kann etwa mittels Affinitäts-Tags, Antigenen oder Antikörpern erfolgen. In einer besonders vorteilhaften Ausführungsvariante für pseudoergodische *lab-on-chip*-Konfigurationen wird nicht-spezifische Adsorption unterbunden. Pseudoergodische *lab-on*-*chip*-Konfigurationen lassen sich beispielsweise für Immunoassays und/oder für die Untersuchung von Antigen-Antikörper-Affinitäten einsetzen. In einer vorteilhaften Ausführungsvariante pseudoergodischer *lab-on-chip*-Konfigurationen erfolgt die Immobilisierung jeweils eines Antikörpers und/oder Antigens pro punktförmiger Beschichtung (18) in der als "site-directed"^{lv} bezeichneten Art und Weise.

Die in der vorstehenden Beschreibung, in den Ansprüchen sowie den beiliegenden Zeichnungen offenbarten Merkmale der Erfindung können sowohl einzeln als auch in jeder beliebigen Kombination für die Verwirklichung der Erfindung in ihren verschiedenen Ausführungsformen wesentlich sein.
ⁱ K. Maejima, S. Tomikawa, K. Suzuki, D. Citterio, RSC Adv. 2013, 3, 9258.
ⁱⁱ Z. Dong, J. Ma, L. Jiang, ACS Nano 2013, 11, 10371.
ⁱⁱⁱ A. Jaworek, A. T. Sobczyk, J. Electrostat. 2008, 66, 197.
^{iv} R.D. Piner, J. Zhu, F. Xu, S.H. Hong, C.A. Mirkin, Science 1999, 283, 661.
^{v} A.B. Braunschweig, F. Huo, C.A. Mirkin, Nat. Chem. 2009, 1, 353.
^{vi} B. Basnar, I. Willner, Small 2009, 5, 28.
^{vii} L. G. Rosa, J. Liang, J. Phys. Condens. Matter 2009, 21, 483001.
^{viii} Z. Xie, X. Zhou, X. Tao, Z. Zheng, Macromol. Rapid Commun. 2012, 33, 359.
^{ix} Y. Xia, G. M. Whitesides, Annu. Rev. Mater. Sci. 1998,28, 153.
^{x} M. Cavallini, F. Biscarini, Nano Lett. 2003, 3, 1269.
^{xi} L. J. Guo, Adv. Mater. 2007, 19, 495.
^{xii} F. Huo, Z. Zheng, G. Zheng, L. R. Giam, H. Zhang, C. A. Mirkin, Science 2008, 321, 1658.
^{xiii} A. Meister, M. Liley, J. Brugger, R. Pugin, H. Heinzelmann, Appl. Phys. Lett. 2004, 85, 6260.
^{xiv} S.G. Vengasandra, M. Lynch, J. T. Xu, E. Henderson, Nanotechnology 2005, 16, 2052.
^{xv} A. Fang, E. Dujardin, T. Ondarçuhu, Nano Lett. 2006, 6, 2368.
^{xvi} L. Fabie, T. Ondarçuhu, Soft Matter 2012, 8, 4995.
^{xvii} J. Hu, M.-F. Yu, Science 2010, 329, 313.
^{xviii} J. J. Dumond, H. Y. Low, J. Vac. Sci. Technol. B 2012, 30, 010801.
^{xix} H. Masuda, K. Fukuda, Science 1995, 268, 1466.
^{xx} H. Masuda, K. Yada, A. Osaka. Jpn. J. Appl. Phys. 1998, 37, L1340.
^{xxi} S. Grimm et al., Nano Lett. 2008, 8, 1954.
^{xxii} G. T. Rengarajan, L. Walder, S. N. Gorb, M. Steinhart, ACS Appl. Mater. Interf. 2012, 4, 1169.
^{xxiii} M. Steinhart, G. T. Rengarajan, H. Schäfer, Körper aus einem Matrixmaterial sowie Verfahren zur Herstellung und Verwendung eines solchen Körpers. German Patent DE 10 2011 053 612 issued 20. 9.2012.
^{xxiv} H. J. Nam, D.-Y. Jung, G.-R. Yi, H. Choi, Langmuir 2006, 22, 7358.
^{xxv} Y. Wang, U. Gösele, M. Steinhart, Chem. Mater. 2008, 20, 379.
^{xxvi} Y. Wang, U. Gösele, M. Steinhart, Nano Lett. 2008, 8, 3548.
^{xxvii} Y. Wang, L. Tong, M. Steinhart, ACS Nano 2011, 5,1928.
^{xxviii} L. Xue, A. Kovalev, F. Thöle, G. T. Rengarajan, M. Steinhart, S. N. Gorb, Langmuir 2012, 28, 10781.
^{xxix} Y. Wang, C. He, W. Xing, F. Li, L. Tong, Z. Chen, X. Liao, M. Steinhart, Adv. Mater. 2010, 22, 2068.
^{xxx} R. Deng, S. Liu, J. Li, Y. Liao, J. Tao, J. Zhu, Adv. Mater. 2012, 24, 1889.
^{xxxi} N. Zhou, F. S. Bates, T. P. Lodge, Nano Lett. 2006, 6, 2354.
^{xxxii} T. Leïchlé, L. Tanguy, L. Nicu, Appl. Phys. Lett. 2007,91, 224102.
^{xxxiii} K. Kaisei, N. Satoh, K. Kobayashi, K. Matsushige, H. Yamada, Nanotechnology 2011, 22, 175301.
^{xxxiv} F. Mugele, J.-C. Baret, J. Phys.: Condens. Matter 2005, 17, R705.
^{xxxv} R. Shamai, D. Andelman, B. Berge, R. Hayes, Soft Matter 2008, 4, 38.
^{xxxvi} C. Laslau, D. E. Williams, J. Travas-Sejdic, Prog. Polym. Sei. 2012, 37, 1177.
^{xxxvii} N. Aydemir et al., Macromol. Rapid Commun. 2013, 34, 1296.
^{xxxviii} K. McKelvey, M. A. O'Connell, P. R. Unwin, Chem. Commun. 2013, 49, 2986.
^{xxxix} A. Zabala Ruiz, H. Li, G. Calzaferri, Angew. Chem. Int. Ed. 2006, 45, 5282.
^{xl} K. B. Yoon, Acc. Chem. Res. 2007, 40, 29.
^{xli} J. S. Beck et al., J. Am. Chem. Soc. 1992, 114, 10834.
^{xlii} D. Zhao et al., Science 1998, 279, 548.
^{xliii} V. Alfredsson, M. W. Anderson, Chem. Mater. 1996, 8, 1141.
^{xliv} K. M. McGrath, D. M. Dabbs, N. Yao, I. A. Aksay, S. M. Gruner, Science 1997, 277, 552.
^{xlv} Y. Lu et al., Nature 1997, 389, 364.
^{xlvi} H. Menzel, M. D. Mowery, M. Cai, C. E. Evans, J. Phys. Chem. B 1998, 102, 9550.
^{xlvii} H. Menzel, S. Horstmann, M. D. Mowery, M. Cai, C. E. Evans, Polymer 2000,41, 8113.
^{xlviii} Y. Wang, R. Xiong, L. Dong, A. Hu, J. Mater. Chem. A 2014, 2, 5212.
^{xlix} W. Eck, A. Küller, M. Grunze, B. Völkel, A. Gölzhäuser, Adv. Mater. 2005, 17, 2583.
^{l} X. Li, P. W. Bohn, Appl. Phys. Lett. 2000, 77, 2572.
^{li} Z. Huang, H. Fang, J. Zhu, Adv. Mater. 2007, 19, 744.
^{lii} K. Peng, A. Lu, R. Zhang, S.-T. Lee, Adv. Funct. Mater. 2008, 18, 3026.
^{liii} S.-W. Chang, V. P. Chuang, S. T. Boles, C. A. Ross, C. V. Thompson, Adv. Funct. Mater. 2009, 19, 2495.
^{liv} Z. Huang et al., Nano Lett. 2009, 9, 2519.
^{lvlv} A. Makaraviciute, A. Ramanaviciene, Biosensors Bioelectronics 2013, 50, 460.

## Patentansprüche

1. Verfahren zur Durchführung eines Kapillar-Nanodrucks, umfassend die Schritte:
a) Bereitstellen einer Vorrichtung, umfassend zumindest eine monolithische Kombination aus einem Substrat (1) und einem oder mehreren Kontaktelementen (2), wobei zumindest Teile der Kontaktelemente (2) eine poröse Struktur haben, vorzugsweise auch zumindest Teile des Substrats eine poröse Struktur haben, besonders bevorzugt die gesamte monolithische Kombination eine poröse Struktur hat;
b) Bereitstellen einer zu bedruckenden Oberfläche (3);
c) Bereitstellen einer Tinte (4) in zumindest einem Teil der porösen Struktur der monolithischen Kombination;
d) Verringern des Abstands zwischen der zu bedruckenden Oberfläche (3) und den Kontaktelementen (2), um eine oder mehrere Kapillarbrücken aus Tinte (4) zwischen den Kontaktelementen (2) und der zu bedruckenden Oberfläche (3) auszubilden;
e) anschließendes Vergrößern des Abstands zwischen den Kontaktelementen (2) und der zu bedruckenden Oberfläche (3), wobei die Kontaktelemente (2) und Oberfläche (3) nach erfolgter Annäherung und vor dem Vergrößern des Abstandes für eine ausgewählte Zeit in einem bestimmten konstanten Abstand voneinander gehalten werden können oder aber das Vergrößern des Abstandes unmittelbar nach Beendigung der Annäherung von Kontaktelementen (2) und Oberfläche (3) erfolgen kann.

2. Verfahren zur Durchführung eines Kapillar-Nanodruck-Verfahrens nach Anspruch 1, wobei die poröse Struktur ein isotropes oder anisotropes kontinuierliches Porensystem aufweist, welches vorzugsweise Bestandteil einer bikontinuierlich-interpenetrierenden Morphologie ist, und/oder wobei die Oberfläche der monolithischen Kombination aus Substrat (1) und Kontaktelementen (2) zumindest in Teilbereichen Porenöffnungen aufweist und bevorzugt die Substrat (1) entgegengesetzten Enden der Kontaktelemente (2) zumindest in Teilbereichen Porenöffnungen aufweisen und vorzugsweise der der Anteil der Porenöffnungen an der Oberfläche der Porenöffnungen aufweisenden Teilbereiche der Gesamtoberfläche der monolithischen Kombination aus Substrat (1) und Kontaktelementen (2) größer als 10%, vorzugsweise größer als 25%, insbesondere bevorzugt größer als 40%, ist.

3. Verfahren nach einem der vorangehenden Ansprüche, wobei die monolithische Kombination aus Substrat (1) und Kontaktelementen (2) zumindest ein Material enthält, das ausgewählt ist aus:
i) organischen Polymeren wie Poly(p-xylylen), Polyacrylamid, Polyimiden, Polyestern, Polyolefinen, Polystyrolen, Polycarbonaten, Polyamiden, Polyethern, Polyphenylen, Polysilanen, Polysiloxanen, Polybenzimidazolen, Polybenzthiazolen, Polyoxazolen, Polysulfiden, Polyesteramiden, Polyarylenvinylenen, Polylactiden, Polyetherketonen, Polyurethanen, Polysulfonen, Ormoceren, Polyacrylaten, Siliconen, vollaromatischen Copolyestern, Poly-N-vinylpyrrolidon, Polyhydroxyethylmethacrylat, Polymethylmethacrylat, Polyethylenterephthalat, Polybutylentherephthalat, Polymethacrylnitril, Polyacrylnitril, Polyvinylacetat, Neopren, Buna N, Polybutadien, Polyethylenen,
ii) fluorhaltigen Polymeren wie Polyvinylidendifluorid, Polytrifluorethylen, Polytretrafluorethylen, Polyhexafluorpropylen,
iii) Dendrimeren und/oder sternartigen Polymeren und/oder kammartigen Polymeren,
iv) biologischen Polymeren wie Polysacchariden, Cellulose (modifiziert oder nichtmodifiziert), Alginaten, Polypeptiden, Collagen, DNA, RNA,
v) Polymeren, die aus mindestens zwei verschiedenen Wiederholungseinheiten aufgebaut sind, bevorzugt in Form von statistischen Copolymeren und/oder Blockcopolymeren und/oder Propfcopolymeren und/oder Dendrimeren,
vi) Blockcopolymeren, die zumindest zwei Blöcke unterschiedlicher Polarität enthalten, wobei besagte Blöcke unter anderem ausgewählt sein können aus Polystyrol-Blöcken und/oder Polyisopren-Blöcken und/oder Polybutadien-Blöcken und/oder Polypropylen-Blöcken und/oder Polyethylen-Blöcken und/oder Poly(methylmethacrylat)-Blöcken und/oder Poly(vinylpyridin)-Blöcken und/oder Poly(vinylpyrrolidon)-Blöcken und/oder Poly(vinylalkohol)-Blöcken und/oder Poly(ethylenoxid)-Blöcken und/oder Poly(propylenoxid)-Blöcken und/oder Poly(butylmethacrylat)-Blöcken und/oder Poly(N-isopropyl-acrylamid)-Blöcken und/oder Poly(dimethylsiloxan)-Blöcken und/oder Polyacrylat-Blöcken und/oder Poly(vinylacetat)-Blöcken und/oder Poly(vinyliden difluorid)-Blöcken und/oder Polythiophen-Blöcken und/oder Poly(styrolsulfonat)-Blöcken,
vii) Copolymeren, die fluorhaltige Comonomere enthalten, bevorzugt fluorhaltige Comonomere, die sich aus Fluorethylen, Difluorethylen, Trifluorethylen, Tetrafluorethylen oder Hexafluorpropylen ableiten,
viii) leitfähigen und/oder halbleitenden Polymeren,
ix) Polyelektrolyten,
x) Kombinationen aus zwei oder mehreren Polymeren und/oder anorganischen Materialien,
xi) Metallen, vorzugsweise Gold, Silber, Platin, Palladium, Wolfram, Kupfer, Titan, Aluminium, Tantal,
xii) beliebigen Mischungen verschiedener Metalle,
xii) Oxiden, die zumindest ein Metall und Sauerstoff oder zumindest einen Halbleiter und Sauerstoff enthalten, vorzugsweise Siliziumoxid, Titanoxid, Aluminiumoxid und Tantaloxid,
xiii) anorganischen Halbleitern, vorzugsweise Silizium,
und Mischungen derselben.

4. Verfahren nach einem der vorangehenden Ansprüche, wobei die Kontaktelemente (2) stabförmig, zylindrisch, kugelförmig, halbkugelförmig, rechteckig, quadratisch, streifenförmig, röhrchenartig oder hohlzylinderartig sind, und/oderwobei die dem Substrat (1) abgewandten Enden der Kontaktelemente (2) halbkugelförmig, pyramidal oder eben sind oder Hohlzylinderöffnungen darstellen.

5. Verfahren nach einem der vorangehenden Ansprüche, wobei die den Kontaktelementen (2) abgewandte Seite des Substrats (1) mit einer weiteren porösen Schicht verbunden ist.

6. Verfahren nach einem der vorangehenden Ansprüche, wobei das Substrat (1) zylinderförmig oder zylindermantelförmig ist und die Kontaktelemente (2) an der äußeren Oberfläche des zylinderförmigen oder zylindermantelförmigen Substrats (1) angeordnet sind.

7. Verfahren nach Anspruch 6, umfassend die Schritte:
a) Bereitstellen einer Vorrichtung nach Anspruch 6;
b) Bereitstellen einer zu bedruckenden Oberfläche (3);
c) Bereitstellen einer Tinte in zumindest einem Teil der porösen Struktur der monolithischen Kombination;
d) Verringern des Abstands zwischen der zu bedruckenden Oberfläche (3) und den Kontaktelementen (2), wobei das Verringern des Abstands zwischen der zu bedruckenden Oberfläche (3) und den Kontaktelementen (2) vor oder nach dem Bereitstellen einer Tinte in zumindest einem Teil der porösen Struktur der monolithischen Kombination erfolgen kann;
e) Bewegung der zu bedruckenden Fläche (3) in Kontakt mit der Vorrichtung nach Anspruch 7, in welcher die monolithische Kombination aus Substrat (1) und Kontaktelementen (2) eine Rotationsbewegung um ihre Längsachse ausführt, oder Rollen der in einer Vorrichtung nach Anspruch 10 enthaltenen monolithischen Kombination aus Substrat (1) und Kontaktelementen (2) über Oberfläche (3).
f) Rotationsbewegung der in einer Vorrichtung nach Anspruch 10 enthaltenen monolithischen Kombination aus Substrat (1) und Kontaktelementen (2) um deren Längsachse relativ zur zu bedruckenden Oberfläche (3) derart, dass sich zwischen den der Oberfläche (3) zugewandten Kontaktelementen (2) und Oberfläche (3) zunächst Kapillarbrücken aus Tinte (4) bilden, welche bei Fortsetzen der Rotationsbewegung und der so erfolgten Entfernung der betroffenen Kontaktelemente von Oberfläche (3) brechen, wohingegen sich neue Kapillarbrücken zwischen neu der Oberfläche (3) zugewandten Kontaktelementen (2) und Oberfläche (3) bilden, die wiederum durch Fortsetzen der Rotationsbewegung brechen, wobei dieser Prozess entsprechend der Erfordernisse der Applikation immer weiter fortgesetzt werden kann.

8. Verfahren nach einem der vorangehenden Ansprüche, wobei die Tinte kontinuierlich oder schubweise an die Kontaktelemente (2) herangeführt wird.

9. Verfahren nach einem der vorangehenden Ansprüche, wobei das Verringern und/oder das Vergrößern des Abstands zwischen den Kontaktelementen (2) und der zu bedruckenden Oberfläche (3) mit einer Geschwindigkeit von höchstens 1 µm/s, vorzugsweise 100 nm/s, besonders bevorzugt 10 nm/s erfolgt, und/oder wobei das Ausbilden der Kapillarbrücke aus Tinte (4) durch Messung der zur Annäherung erforderlichen Kraft und/oder durch Erzeugung eines elektrischen Kontakts zwischen der monolithischen Kombination aus Substrat (1) und Kontaktelementen (2) sowie der zu bedruckenden Oberfläche (3) detektiert wird.

10. Verfahren nach einem der vorangehenden Ansprüche, wobei beim Vergrößern des Abstands zwischen den Kontaktelementen (2) und der zu bedruckenden Oberfläche (3) die Kapillarbrücken aus Tinte (4) unterbrochen werden, um Tintentropfen (5) auf der zu bedruckenden Oberfläche (3) zu erzeugen.

11. Feld von Tintentropfen (5) auf einer Oberfläche (3), erhältlich nach einem Verfahren der Ansprüche 1 bis 10, wobei die Tintentropfen (5) jeweils ein Volumen von höchsten einem Pikoliter, vorzugsweise einem Femtoliter, besonders bevorzugt einem Attoliter, haben.

12. Feld von Drähten (7) erhältlich nach einem Verfahren der Ansprüche 1 bis 10

13. Feld von Drähten (7) nach Anspruch 12, wobei die Längsachsen der Drähte mit der Oberfläche (3) Winkel von 90°, bevorzugt von kleiner als 90°, besonders bevorzugt von kleiner als 75° und am meisten bevorzugt von kleiner als 60° einschließen

14. Feld von Drähten (7) nach Anspruch 12 oder 13, wobei die Drähte (7) einen Durchmesser von weniger als 500 nm, vorzugsweise 100 nm, besonders bevorzugt 30 nm, haben, und/oder wobei die Drähte (7) eine Länge von mehr als 500 nm, vorzugsweise mehr als 1 µm, besonders bevorzugt 5 µm, haben, und/oder wobei die Beschichtungen (18) jeweils einen Durchmesser von weniger als einem Mikrometer, bevorzugt von weniger als 100 nm, und besonders bevorzugt von weniger als 20 nm haben.

## Claims

1. A method for performing capillary nanoprinting, comprising the steps of:
a) providing a device comprising at least one monolithic combination of a substrate (1) and one or more contact elements (2), wherein at least parts of the contact elements (2) have a porous structure, preferably also at least parts of the substrate have a porous structure, more preferably the whole monolithic combination has a porous structure;
b) providing a surface (3) to be printed;
c) providing an ink (4) in at least part of the porous structure of the monolithic combination;
d) reducing the distance between the surface (3) to be printed and the contact elements (2) to form one or more capillary bridges of ink (4) between the contact elements (2) and the surface (3) to be printed;
e) subsequently increasing the distance between the contact elements (2) and the surface (3) to be printed, wherein the contact elements (2) and surface (3) can be kept at a certain constant distance from each other after approach and before increasing the distance for a selected time or increasing the distance can be done immediately after the approach of contact elements (2) and surface (3) has ended.

2. The method for performing a capillary nanoprinting method according to claim 1, wherein the porous structure has an isotropic or anisotropic continuous pore system, which is preferably part of a bicontinuous-interpenetrating morphology, and/or wherein the surface of the monolithic combination of substrate (1) and contact elements (2) has pore openings at least in partial areas and preferably the substrate (1) has opposite ends of the contact elements (2) have pore openings at least in partial areas and preferably the partial areas of the total surface of the monolithic combination of substrate (1) and contact elements (2) having the proportion of pore openings at the surface of the pore openings is greater than 10%, preferably greater than 25%, particularly preferably greater than 40%.

3. The method according to any one of the preceding claims, wherein the monolithic combination of substrate (1) and contact elements (2) contains at least one material selected from:
i) organic polymers such as poly(p-xylylene), polyacrylamide, polyimides, polyesters, polyolefins, polystyrenes, polycarbonates, polyamides, polyethers, polyphenylene, polysilanes, polysiloxanes, polybenzimidazoles, polybenzthiazoles, polyoxazoles, polysulphides, polyesteramides, polyarylene vinylenes, polylactides, polyether ketones, polyurethanes, polysulfones, ormocers, polyacrylates, silicones, fully aromatic copolyesters, poly-N-vinylpyrrolidone, polyhydroxyethyl methacrylate, polymethyl methacrylate, polyethylene terephthalate, polybutylene terephthalate, polymethacrylonitrile, polyacrylonitrile, polyvinyl acetate, neoprene, Buna N, polybutadiene, polyethylenes,
ii) fluorine-containing polymers such as polyvinylidene difluoride, polytrifluoroethylene, polytetrafluoroethylene, polyhexafluoropropylene,
iii) dendrimers and/or star-like polymers and/or comb-like polymers,
iv) biological polymers such as polysaccharides, cellulose (modified or unmodified), alginates, polypeptides, collagen, DNA, RNA,
v) polymers which are constructed from at least two different repeating units, preferably in the form of random copolymers and/or block copolymers and/or graft copolymers and/or dendrimers,
vi) block copolymers which contain at least two blocks of different polarity, wherein said blocks can be selected inter alia from polystyrene blocks and/or polyisoprene blocks and/or polybutadiene blocks and/or polypropylene blocks and/or polyethylene blocks and/or poly(methyl methacrylate) blocks and/or poly(vinyl pyridine) blocks and/or poly(vinyl pyrrolidone) blocks and/or poly(vinyl alcohol) blocks and/or poly(ethylene oxide) blocks and/or poly(propylene oxide) blocks and/or poly(butyl methacrylate) blocks and/or poly(N-isopropyl acrylamide) blocks and/or poly(dimethylsiloxane) blocks and/or polyacrylate blocks and/or poly(vinyl acetate) blocks and/or poly(vinylidene difluoride) blocks and/or polythiophene blocks and/or poly(styrene sulfonate) blocks,
vii) copolymers containing fluorine-containing comonomers, preferably fluorine-containing comonomers derived from fluoroethylene, difluoroethylene, trifluoroethylene, tetrafluoroethylene or hexafluoropropylene,
viii) conductive and/or semiconductive polymers,
ix) polyelectrolytes,
x) combinations of two or more polymers and/or inorganic materials,
xi) metals, preferably gold, silver, platinum, palladium, tungsten, copper, titanium, aluminium, tantalum,
xii) any desired mixtures of different metals,
xii) oxides which contain at least one metal and oxygen or at least one semiconductor and oxygen, preferably silicon oxide, titanium oxide, aluminium oxide and tantalum oxide,
xiii) inorganic semiconductors, preferably silicon,
and mixtures thereof.

4. The method according to any one of the preceding claims, wherein the contact elements (2) are rod-shaped, cylindrical, spherical, hemispherical, rectangular, square, strip-shaped, tube-like or hollow cylinder-like, and/or wherein the ends of the contact elements (2) facing away from the substrate (1) are hemispherical, pyramidal or planar or represent hollow cylinder openings.

5. The method according to any one of the preceding claims, wherein the side of the substrate (1) facing away from the contact elements (2) is connected to a further porous layer.

6. The method according to any one of the preceding claims, wherein the substrate (1) is cylindrical or cylinder jacket-shaped and the contact elements (2) are arranged on the outer surface of the cylindrical or cylinder jacket-shaped substrate (1).

7. The method according to claim 6, comprising the steps of:
a) providing a device according to claim 6;
b) providing a surface (3) to be printed;
c) providing an ink in at least part of the porous structure of the monolithic combination;
d) reducing the distance between the surface (3) to be printed and the contact elements (2), wherein reducing the distance between the surface (3) to be printed and the contact elements (2) can be done before or after providing an ink in at least part of the porous structure of the monolithic combination;
e) moving the surface (3) to be printed into contact with the device according to claim 7, in which the monolithic combination of substrate (1) and contact elements (2) performs a rotational movement around its longitudinal axis, or rolling the monolithic combination of substrate (1) and contact elements (2) contained in a device according to claim 10 over surface (3).
f) rotational movement of the monolithic combination of substrate (1) and contact elements (2) contained in a device according to claim 10 around its longitudinal axis relative to the surface (3) to be printed, such that between the contact elements (2) and surface (3) facing the surface (3) capillary bridges of ink (4) initially form, which upon continuation of the rotational movement and the removal of the affected contact elements from surface (3), break, whereas new capillary bridges form between contact elements (2) and surface (3) newly facing the surface (3), which in turn break by continuation of the rotational movement, wherein this process can be continued according to the requirements of the application.

8. The method according to any one of the preceding claims, wherein the ink is supplied continuously or intermittently to the contact elements (2).

9. The method according to any one of the preceding claims, wherein reducing and/or increasing the distance between the contact elements (2) and the surface (3) to be printed is done at a speed of at most 1 µm/s, preferably 100 nm/s, more preferably 10 nm/s, and/or wherein forming the capillary bridge of ink (4) is detected by measuring the force required for approach and/or by generating an electrical contact between the monolithic combination of substrate (1) and contact elements (2) and the surface (3) to be printed.

10. The method according to any one of the preceding claims, wherein when increasing the distance between the contact elements (2) and the surface (3) to be printed, the capillary bridges of ink (4) are interrupted to generate ink drops (5) on the surface (3) to be printed.

11. An array of ink drops (5) on a surface (3) obtainable according to a method according to any one of claims 1 to 10, wherein the ink drops (5) each have a volume of at most one picoliter, preferably one femtoliter, more preferably one attoliter.

12. An array of wires (7) obtainable according to a method according to a method according to any one of claims 1 to 10.

13. An array of wires (7) according to claim 12, wherein the longitudinal axes of the wires with the surface (3) include angles of 90°, preferably of less than 90°, more preferably of less than 75°, and most preferably of less than 60°.

14. An array of wires (7) according to claim 12 or 13, wherein the wires (7) have a diameter of less than 500 nm, preferably 100 nm, more preferably 30 nm, and/or wherein the wires (7) have a length of more than 500 nm, preferably more than 1 ym, more preferably 5 ym, and/or wherein the coatings (18) each have a diameter of less than one micrometer, preferably of less than 100 nm, and more preferably of less than 20 nm.

## Revendications

1. Procédé pour la réalisation d'une nanopression capillaire, comprenant les étapes :
a) mise à disposition d'un dispositif, comprenant au moins une combinaison monolithique constituée par un substrat (1) et un ou plusieurs éléments de contact (2), au moins des parties des éléments de contact (2) présentant une structure poreuse, de préférence également des parties du substrat présentant une structure poreuse, de manière particulièrement préférée l'ensemble de la combinaison monolithique présentant une structure poreuse ;
b) mise à disposition d'une surface à imprimer (3) ;
c) mise à disposition d'une encre (4) dans au moins une partie de la structure poreuse de la combinaison monolithique ;
d) diminution de la distance entre la surface (3) à imprimer et les éléments de contact (2), pour former un ou plusieurs ponts capillaires d'encre (4) entre les éléments de contact (2) et la surface à imprimer (3) ;
e) agrandissement consécutif de la distance entre les éléments de contact (2) et la surface à imprimer (3), les éléments de contact (2) et la surface (3), après la fin du rapprochement et avant l'agrandissement de la distance, étant maintenus pendant un temps sélectionné à une distance constante déterminée les uns des autres ou l'agrandissement de la distance pouvant avoir lieu directement après la fin du rapprochement des éléments de contact (2) et de la surface (3).

2. Procédé pour la réalisation d'un procédé par nanopression capillaire selon la revendication 1, la structure poreuse présentant un système isotrope ou anisotrope continu de pores, qui fait de préférence partie d'une morphologie d'interpénétration bicontinue et/ou la surface de la combinaison monolithique, constituée par le substrat (1) et les éléments de contact, (2) présentant des ouvertures de pore au moins dans des zones partielles et, de préférence, les extrémités des éléments de contact (2), opposées au substrat (1), présentant des ouvertures de pore au moins dans des zones partielles et, de préférence, les zones partielles de la surface totale de la combinaison monolithique, constituée par le substrat (1) et les éléments de contact (2), présentant la proportion d'ouvertures de pore au niveau de la surface des ouvertures de pore étant supérieures à 10%, de préférence supérieures à 25%, en particulier de préférence supérieures à 40%.

3. Procédé selon l'une quelconque des revendications précédentes, la combinaison monolithique, constituée par le substrat (1) et les éléments de contact (2), contenant au moins un matériau qui est choisi parmi :
i) les polymères organiques tels que le poly(p-xylylène), le polyacrylamide, les polyimides, les polyesters, les polyoléfines, les polystyrènes, les polycarbonates, les polyamides, les polyéthers, le polyphénylène, les polysilanes, les polysiloxanes, les polybenzimidazoles, les polybenzothiazoles, les polyoxazoles, les polysulfures, les polyesteramides, les poly(arylène-vinylènes), les polylactides, les polyéthercétones, les polyuréthanes, les polysulfones, les ormocers, les polyacrylates, les silicones, les copolyesters complètement aromatiques, la poly-N-vinylpyrrolidone, le poly(méthacrylate d'hydroxyéthyle), le poly(méthacrylate de méthyle), le poly(téréphtalate d'éthylène), le poly(téréphtalate de butylène), le polyméthacrylonitrile, le polyacrylonitrile, le poly(acétate de vinyle), le néoprène, le Buna N, le polybutadiène, les polyéthylènes,
ii) les polymères contenant du fluor tels que le poly(difluorure de vinylidène), le polytrifluoroéthylène, le polytétrafluoroéthylène, le polyhexafluoropropylène,
iii) les dendrimères et/ou les polymères en étoile et/ou les polymères en peigne,
iv) les polymères biologiques tels que les polysaccharides, la cellulose (modifiée ou non modifiée), les alginates, les polypeptides, le collagène, l'ADN, l'ARN,
v) les polymères qui sont constitués par au moins deux motifs récurrents différents, de préférence sous forme de copolymères statistiques et/ou de copolymères séquencés et/ou de copolymères greffés et/ou de dendrimères,
vi) les copolymères séquencés qui contiennent au moins deux blocs de polarité différente, lesdits blocs pouvant entre autres être choisis parmi les blocs de polystyrène et/ou les blocs de polyisoprène et/ou les blocs de polybutadiène et/ou les blocs de polypropylène et/ou les blocs de polyéthylène et/ou les blocs de poly(méthacrylate de méthyle) et/ou les blocs de poly(vinylpyridine) et/ou les blocs de poly(vinylpyrrolidone) et/ou les blocs de poly(alcool vinylique) et/ou les blocs de poly(oxyde d'éthylène) et/ou les blocs de poly(oxyde de propylène) et/ou les blocs de poly(méthacrylate de butyle) et/ou les blocs de poly(N-isopropylacrylamide) et/ou les blocs de poly(diméthylsiloxane) et/ou les blocs de polyacrylate et/ou les blocs de poly(acétate de vinyle) et/ou les blocs de poly(difluorure de vinylidène) et/ou les blocs de polythiophène et/ou les blocs de poly(styrènesulfonate),
vii) les copolymères qui contiennent des comonomères fluorés, de préférence des comonomères fluorés qui sont dérivés du fluoroéthylène, du difluoroéthylène, du trifluoroéthylène, du tétrafluoroéthylène ou de l'hexafluoropropylène,
viii) les polymères conducteurs et/ou semi-conducteurs,
ix) les polyélectrolytes,
x) les combinaisons de deux polymères et/ou matériaux inorganiques ou plus,
xi) les métaux, de préférence l'or, l'argent, le platine, le palladium, le tungstène, le cuivre, le titane, l'aluminium, le tantale,
xii) les mélanges quelconques de différents métaux,
xii) les oxydes, qui contiennent au moins un métal et de l'oxygène ou au moins un semi-conducteur et de l'oxygène, de préférence l'oxyde de silicium, l'oxyde de titane, l'oxyde d'aluminium et l'oxyde de tantale,
xiii) les semi-conducteurs inorganiques, de préférence le silicium,
et leurs mélanges.

4. Procédé selon l'une quelconque des revendications précédentes, les éléments de contact (2) étant en forme de tige, cylindrique, sphérique, demi-sphérique, rectangulaire, quadratique, en forme de bande, de type tubulaire ou de type cylindrique creux et/ou les extrémités opposées au substrat (1) des éléments de contact (2) étant de forme demi-sphérique, pyramidale ou plane ou représentant des ouvertures de cylindre creux.

5. Procédé selon l'une quelconque des revendications précédentes, le côté du substrat (1) opposé aux éléments de contact (2) étant relié à une autre couche poreuse.

6. Procédé selon l'une quelconque des revendications précédentes, le substrat (1) étant de forme cylindrique ou de forme enveloppe cylindrique et les éléments de contact (2) étant disposés sur la surface externe du substrat (1) de forme cylindrique ou de forme enveloppe cylindrique.

7. Procédé selon la revendication 6, comprenant les étapes :
a) mise à disposition d'un dispositif selon la revendication 6 ;
b) mise à disposition d'une surface à imprimer (3) ;
c) mise à disposition d'une encre dans au moins une partie de la structure poreuse de la combinaison monolithique ;
d) diminution de la distance entre la surface (3) à imprimer et les éléments de contact (2), la diminution de la distance entre la surface (3) à imprimer et les éléments de contact (2) pouvant avoir lieu avant ou après la mise à disposition d'une encre dans au moins une partie de la structure poreuse de la combinaison monolithique ;
e) déplacement de la surface (3) à imprimer en contact avec le dispositif selon la revendication 7, lors duquel la combinaison monolithique, constituée par le substrat (1) et les éléments de contact (2), effectue un mouvement de rotation autour de son axe longitudinal ou roulement de la combinaison monolithique, constituée par le substrat (1) et les éléments de contact (2), contenue dans un dispositif selon la revendication 10 sur la surface (3),
f) mouvement de rotation de la combinaison monolithique, constituée par le substrat (1) et les éléments de contact (2), contenue dans un dispositif selon la revendication 10 autour de son axe longitudinal par rapport à la surface (3) à imprimer de manière telle que des ponts capillaires d'encre (4) se forment d'abord entre les éléments de contact (2) orientés vers la surface (3) et la surface (3), qui se rompent lors de la poursuite du mouvement de rotation et de l'éloignement ainsi réalisé entre les éléments de contact en question et la surface (3) alors que de nouveaux ponts capillaires se forment entre des éléments de contact (2) nouvellement orientés vers la surface (3) et la surface (3), qui se rompent de nouveau par la poursuite du mouvement de rotation, ce processus pouvant être poursuivi continuellement conformément aux exigences de l'application.

8. Procédé selon l'une quelconque des revendications précédentes, l'encre étant amenée en continu ou par fournée aux éléments de contact (2).

9. Procédé selon l'une quelconque des revendications précédentes, la diminution et/ou l'agrandissement de la distance entre les éléments de contact (2) et la surface (3) à imprimer étant réalisé(e) (s) à une vitesse d'au plus 1 µm/s, de préférence de 100 nm/s, de manière particulièrement préférée de 10 nm/s et/ou la formation des ponts capillaires d'encre (4) étant détectée par mesure de la force nécessaire pour le rapprochement et/ou par génération d'un contact électrique entre la combinaison monolithique, constituée par le substrat (1) et les éléments de contact (2), d'une part et la surface (3) à imprimer d'autre part.

10. Procédé selon l'une quelconque des revendications précédentes, où, lors de l'agrandissement de la distance entre les éléments de contact (2) et la surface (3) à imprimer, les ponts capillaires d'encre (4) sont rompus pour générer des gouttes d'encre (5) sur la surface (3) à imprimer.

11. Champ de gouttes d'encre (5) sur une surface (3), pouvant être obtenu selon un procédé selon les revendications 1 à 10, les gouttes d'encre (5) présentant à chaque fois un volume représentant au plus un picolitre, de préférence un femtolitre, de manière particulièrement préférée un attolitre.

12. Champ de fils (7) pouvant être obtenu selon un procédé selon les revendications 1 à 10.

13. Champ de fils (7) selon la revendication 12, les axes longitudinaux des fils formant, avec la surface (3) des angles de 90°, de préférence inférieurs à 90°, de manière particulièrement préférée inférieurs à 75° et le plus préférablement inférieurs à 60°.

14. Champ de fils (7) selon la revendication 12 ou 13, les fils (7) présentant un diamètre inférieur à 500 nm, de préférence de 100 nm, de manière particulièrement préférée de 30 nm et/ou les fils (7) présentant une longueur supérieure à 500 nm, de préférence supérieure à 1 µm, de manière particulièrement préférée de 5 µm et/ou les revêtements (18) présentant à chaque fois un diamètre inférieur à un micromètre, de préférence inférieur à 100 nm et de manière particulièrement préférée inférieur à 20 nm.
